# EUROPÄISCHE PATENTANMELDUNG

(11) **EP 4 236 640 A1**
(43) Veröffentlichungstag der Anmeldung: **30.08.2023**
(21) Anmeldenummer: 22158286.9
(22) Anmeldetag: 23.02.2022
(51) Int. Cl.: H05K 5/00, H05K 7/14

(54) **HALTERUNG FÜR EINE LEITERPLATTE**

(71) Anmelder: Siemens Aktiengesellschaft, 80333 München (DE)
(72) Erfinder: Baader, Mathias, 76437 Rastatt (DE)
(74) Vertreter: Siemens Patent Attorneys

(57) **Zusammenfassung**

Halterung für eine Leiterplatte. Anordnung zur Befestigung einer Leiterplatte (4), die Anordnung umfassend: ein erstes röhrenförmiges Befestigungselement (6) und einen ersten Leiter innen im ersten röhrenförmigen Befestigungselement (6); die Anordnung umfassend eine Halterung (2) für die Leiterplatte (4); wobei die Halterung (2) mindestens einen Vorsprung zur mechanischen Befestigung der Leiterplatte (4) umfasst; wobei die Halterung (2) eine erste Öffnung umfasst; wobei das erste röhrenförmige Befestigungselement (6) durch die erste Öffnung in der Halterung (2) geführt ist; wobei das erste röhrenförmige Befestigungselement (6) mechanisch derart fest mit der Halterung (2) verbunden ist, dass die Halterung (2) gegenüber dem ersten röhrenförmigen Befestigungselement (6) substanziell unbeweglich ist; die Anordnung umfassend einen ersten Anschluss zur starren Verbindung des ersten Leiters mit der Leiterplatte (4); wobei das erste röhrenförmige Befestigungselement (6) ein Ende umfasst, welches von der Halterung (2) weggerichtet ist; wobei der erste Anschluss am Ende des ersten röhrenförmigen Befestigungselementes (6) ist.

## Beschreibung

### Hintergrund

Die vorliegende Offenbarung bezieht sich auf eine Halterung für eine Leiterplatte. Insbesondere bezieht sich die vorliegende Offenbarung auf eine Halterung für eine Leiterplatte, wobei die Halterung gegenüber einem Gehäuse eines Gerätes gesichert ist.

Elektrische Geräte wie beispielsweise Steuerungen von Gasbrennern und/oder von Ölbrennern und/oder von Ventilen sind häufig gegen Einwirkung von Fremdkörpern zu schützen. Weiterhin sind solche Geräte häufig gegen Einwirkung von Wasser zu schützen. Je nach Schutzklasse wird dabei ein Schutz vor Fremdkörpern mit bestimmten Durchmessern, beispielsweise zwölf Millimeter oder 2.5 Millimeter oder ein Millimeter bereitgestellt. Weiterhin sind ein Schutz vor Staub und sogar ein vollständiger Schutz vor Staubeintritt möglich.

Ein Schutz gegen Einwirkung von Staub und/oder Fremdkörpern und/oder Wasser bedingt vielfach eine weitgehende technische Trennung der mechanischen Befestigung einer Platine am Gehäuse von der elektrischen Verdrahtung. Eine besondere Herausforderung ist dabei die Beherrschung der Toleranzkette innerhalb des zu schützenden Gerätes. So sind jedwede Kontaktträger zur Gehäuseverschraubung präzise auszurichten. Zugleich ist eine Leiterplatte im Gehäuse mechanisch zu befestigen. Die gegenseitige Ausrichtung von Leiterplatte, Kontaktträgern und Gehäuse wird teils unter hohem technischen Aufwand sichergestellt.

Vielfach werden zur Beherrschung der Toleranzkette sogenannte Kabel-an-Leiterplatte Steckverbinder eingesetzt. Dabei wird eine flexible elektrische Verbindung, beispielsweise ein Flachbandkabel und/oder ein Bandstecker, anhand eines Steckers an einem Sockel befestigt. Beispielsweise werden im Rahmen solcher Kabel-an-Leiterplatte Verbindungen Stecker und Sockel auf gedruckten Leiterplatten angebracht.

Jene Sockel, Stecker und jene flexiblen elektrischen Verbindungen sind zusätzliche Komponenten innerhalb eines Gerätes, beispielsweise innerhalb einer Ventilsteuerung. Stecker und Sockel können sich unter anderem infolge mechanischer Vibrationen lösen. Flexible elektrische Verbindungen wie Flachbandkabel und/oder Bandstecker und insbesondere solche flexible Verbindungen aus Kupferdrähten überstehen eine begrenzte Zahl an Wechselbiegezyklen. Anschliessend können solche flexible elektrische Verbindungen brechen. Das Lösen einer Steckverbindung wie auch der Bruch einer flexiblen elektrischen Verbindung führen vielfach zum Ausfall des Gerätes.

Eine deutsche Patentanmeldung DE3011243A1 wurde eingereicht am 24. März 1980 durch die Siemens AG. Die Anmeldung wurde veröffentlicht am 1. Oktober 1981. DE3011243A1 behandelt eine Verriegelungsvorrichtung für eine Lagerachse.

Dabei wird eine Platte anhand einer Befestigung gesichert. Die Befestigung umfasst einen Kopf und einen Schaft. Zur Sicherung der Platte an dem Schaft stehen vom Schaft diametral Stege ab. Die Stege weisen Nocken auf, welche zur Sicherung der Platte mit Rastlöchern der Platte zusammenwirken. Der Schaft wiederum umfasst ein Sackloch, in welchem eine Lagerachse drehbar gelagert ist.

Eine weitere Patentanmeldung DE10226761A1 wurde eingereicht am 14. Juni 2002 durch eine Patent-Treuhand-Gesellschaft für elektrische Glühlampen mbH. Die Anmeldung wurde veröffentlicht am 8. Januar 2004. DE10226761A1 behandelt einen Bajonettsockel für eine Lampenhalterung.

DE10226761A1 lehrt eine Lampenhalterung mit einem Bajonettstecker. Der Bajonettstecker ist anhand einer Bajonettbuchse in eine erste Gefässhälfte der Lampenhalterung eindrehbar. Die erste Gefässhälfte der Lampenhalterung trägt eine Leiterplatte für ein elektrisches Vorschaltgerät. Eine zweite Gefässhälfte der Lampenhalterung umfasst eine Aufnahme für eine Leuchtstoffröhre. Der Bajonettstecker ist in die erste Gefässhälfte der Lampenhalterung, jedoch nicht in die zweite Gefässhälfte, eindrehbar. Für die Verbindung mit einer Wand sind Schraubklemmen oder Steckklemmen vorgesehen. Derartige Klemmen erlauben die Befestigung an einer Wand anhand flexibler elektrischer Leitungen.

Wiederum eine weitere deutsche Patentanmeldung DE102009059013A1 wurde eingereicht am 17. Dezember 2009 durch die Phoenix Contact GmbH & Co. KG. Die Anmeldung wurde veröffentlicht am 22. Juni 2011. DE102009059013A1 behandelt eine Vorrichtung zur Befestigung mindestens einer Leiterplatte an einem Aufnahmeelement.

Das Aufnahmeelement aus DE102009059013A1 ist anhand einer Befestigung mit drei Leiterplatten verbunden. Eine Öffnung in den Leiterplatten ermöglicht die Durchführung der Befestigung durch die Leiterplatten. Eine mittige Fixierung der Leiterplatten am Aufnahmeelement erfolgt anhand von Haltelementen.

Ziel der vorliegenden Offenbarung ist es, eine Leiterplatte so innerhalb eines Gehäuses zu befestigen, dass einerseits Schutz vor Staub und/oder Fremdkörpern und/oder Wasser gewährleistet ist. Anderseits ist auf flexible elektrische Verbindungen wie beispielsweise Flachbandkabel weitgehend zu verzichten.

### Zusammenfassung

Die vorliegende Offenbarung behandelt einen Leiterplattenhalter zur Installation in einem Gerät. Das Gerät kann beispielsweise ein elektrisches und/oder elektronisches Gerät sein. Insbesondere kann das Gerät eine Steuerung für einen Gasbrenner und/oder einen Ölbrenner sein. Ferner kann das Gerät eine Regelung für einen Gasbrenner und/oder einen Ölbrenner sein. Zudem kann das Gerät eine Steuerung und/oder eine Regelung für ein Ventil umfassen. Insbesondere kann das Gerät eine Steuerung und/oder eine Regelung für ein Ventil umfassen. Ausserdem kann das Gerät eine Steuerung und/oder eine Regelung für einen Ventilantrieb umfassen. Insbesondere kann das Gerät eine Steuerung und/oder eine Regelung für einen Ventilantrieb sein.

Der Leiterplattenhalter wird anhand eines Befestigungselementes an einem Gehäuse des Gerätes befestigt. Dabei ist das Befestigungselement mit dem Gehäuse derart fest mechanisch verbunden, dass das Befestigungselement gegenüber dem Gehäuse unbeweglich ist. Zudem ist das Befestigungselement mit dem Leiterplattenhalter derart fest mechanisch verbunden, dass das Befestigungselement gegenüber dem Leiterplattenhalter unbeweglich ist. In einer Ausführungsform umfasst das Befestigungselement mindestens eine Verschraubung. Das Befestigungselement ist vorzugsweise mit dem Gehäuse des Gerätes verschraubt. Das Befestigungselement ist idealerweise mit dem Leiterplattenhalter verschraubt. Vorteilhaft ist das Befestigungselement mit dem Gehäuse des Gerätes und mit dem Leiterplattenhalter verschraubt.

An dem Leiterplattenhalter kann eine Leiterplatte so befestigt werden, dass sie sich innen im Gerät befindet. Dabei definiert das Gehäuse des Gerätes einen Innenbereich des Gerätes. Die Leiterplatte kann vorteilhaft so an dem Leiterplattenhalter mechanisch befestigt werden, dass die Leiterplatte gegenüber dem Leiterplattenhalter unbeweglich ist.

Vorzugsweise umfasst der Leiterplattenhalter mindestens eine Halterung. Der Leiterplattenhalter kann insbesondere zwei oder drei oder vier Halterungen umfassen. In einer Ausführungsform ist der Leiterplattenhalter mit der Leiterplatte anhand der mindestens einen Halterung in Form einer Verschraubung verbunden. In einer weiteren Ausführungsform ist der Leiterplattenhalter mit der Leiterplatte anhand zweier Halterungen in Form von Verschraubungen verbunden. In wiederum einer weiteren Ausführungsform ist der Leiterplattenhalter mit der Leiterplatte anhand dreier Halterungen in Form von Verschraubungen verbunden. In noch einer weiteren Ausführungsform ist der Leiterplattenhalter mit der Leiterplatte anhand von vier Halterungen in Form von Verschraubungen verbunden.

In einer Ausführungsform ist der Leiterplattenhalter mit der Leiterplatte anhand der mindestens einen Halterung in Form einer Vernietung verbunden. In einer weiteren Ausführungsform ist der Leiterplattenhalter mit der Leiterplatte anhand zweier Halterungen in Form von Vernietungen verbunden. In wiederum einer weiteren Ausführungsform ist der Leiterplattenhalter mit der Leiterplatte anhand dreier Halterungen in Form von Vernietungen verbunden. In noch einer weiteren Ausführungsform ist der Leiterplattenhalter mit der Leiterplatte anhand von vier Halterungen in Form von Vernietungen verbunden.

In einer Ausführungsform ist der Leiterplattenhalter mit der Leiterplatte anhand der mindestens einen Halterung in Form einer Verklebung verbunden. In einer weiteren Ausführungsform ist der Leiterplattenhalter mit der Leiterplatte anhand zweier Halterungen in Form von Verklebungen verbunden. In wiederum einer weiteren Ausführungsform ist der Leiterplattenhalter mit der Leiterplatte anhand dreier Halterungen in Form von Verklebungen verbunden. In noch einer weiteren Ausführungsform ist der Leiterplattenhalter mit der Leiterplatte anhand von vier Halterungen in Form von Verklebungen verbunden.

In einer Ausführungsform ist der Leiterplattenhalter mit der Leiterplatte anhand der mindestens einen Halterung in Form einer einrastenden Steckverbindung verbunden. In einer weiteren Ausführungsform ist der Leiterplattenhalter mit der Leiterplatte anhand zweier Halterungen in Form von einrastenden Steckverbindungen verbunden. In wiederum einer weiteren Ausführungsform ist der Leiterplattenhalter mit der Leiterplatte anhand dreier Halterungen in Form von einrastenden Steckverbindungen verbunden. In noch einer weiteren Ausführungsform ist der Leiterplattenhalter mit der Leiterplatte anhand von vier Halterungen in Form von einrastenden Steckverbindungen verbunden.

### Kurze Beschreibung der Zeichnungen

Verschiedene Merkmale werden dem Fachmann aus der folgenden detaillierten Beschreibung der offenbarten nicht einschränkenden Ausführungsformen ersichtlich. Die Zeichnungen, die der detaillierten Beschreibung beiliegen, können kurz wie folgt beschrieben werden:
FIG 1 zeigt eine perspektivische Darstellung eines Geräteteiles mit Leiterplattenhalter, Leiterplatte, Gehäuse und Verschraubung.
FIG 2 zeigt eine weitere Darstellung eines Geräteteiles mit angebrachtem Leiterplattenhalter und mit Leiterplatte.

### Detaillierte Beschreibung

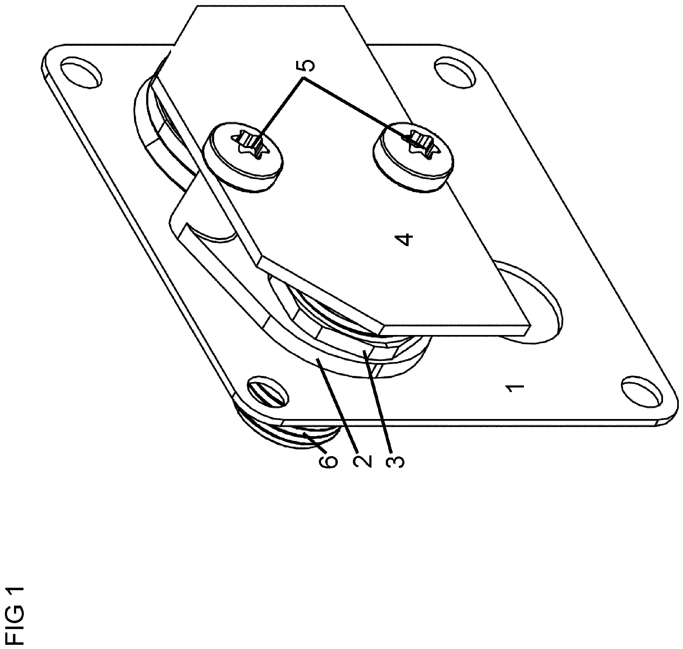

FIG 1 zeigt eine Gehäusewand 1 eines Gerätes, beispielsweise eines elektrischen und/oder elektronischen Gerätes. Die Gehäusewand 1 kann beispielsweise aus einem Metall wie Aluminium und/oder Stahl und/oder ferritischer Stahl und/oder austenitischer Stahl hergestellt sein. Die Gehäusewand 1 kann ebenso aus einem Kunststoff wie beispielsweise Polyvinylchlorid und/oder Polyethylenterephthalat und/oder Acrylnitril-Butadien-Styrol-Copolymer hergestellt sein. Die vorstehenden Listen an Materialien der Gehäusewand 1 sind nicht abschliessend.

In einer Ausführungsform ist die Gehäusewand 1 in einem Spritzgussverfahren hergestellt. Die Gehäusewand 1 oder Teile der Gehäusewand 1 werden nach einem Aspekt der vorliegenden Offenbarung mit einem additiven Herstellungsverfahren wie dem dreidimensionalen Druck hergestellt. Die Herstellung der Gehäusewand 1 und/oder von Teilen der Gehäusewand 1 kann in einer speziellen Ausführungsform durch selektives Lasersintern erfolgen.

Die Gehäusewand 1 weist eine erste Öffnung auf. Die erste Öffnung in der Gehäusewand 1 hat vorzugsweise einen kreisförmigen Querschnitt. Die erste Öffnung in der Gehäusewand 1 kann weiterhin einen quadratischen, rechteckigen oder sechseckigen Querschnitt aufweisen. Die vorstehende Aufzählung von Querschnitten der ersten Öffnung in der Gehäusewand 1 erhebt keinen Anspruch auf Vollständigkeit.

In einer Ausführungsform ist die erste Öffnung in der Gehäusewand 1 eine Bohrung. In einer weiteren Ausführungsform ist die erste Öffnung in der Gehäusewand 1 gestanzt. Weitere technische Möglichkeiten zum Herstellen der ersten Öffnung in der Gehäusewand 1 sind einschlägig bekannt. Beispielsweise kann die erste Öffnung in der Gehäusewand 1 im Rahmen der Herstellung mit einem additiven Herstellungsverfahren als Aussparung angebracht sein.

Durch die erste Öffnung in der Gehäusewand 1 ist ein erster Gewindebolzen 6 geführt. Der erste Gewindebolzen 6 umfasst vorzugsweise einen ersten Hohlzylinder mit einem ersten Aussengewinde, beispielsweise mit einem ersten metrischen Aussengewinde. Der erste Gewindebolzen 6 ist idealerweise ein erster Hohlzylinder mit einem ersten Aussengewinde, beispielsweise mit einem ersten metrischen Aussengewinde.

Der erste Hohlzylinder des ersten Gewindebolzens 6 ist aus einem Material gefertigt, welches kompatibel ist mit dem Material der Gehäusewand 1. Der erste Hohlzylinder des ersten Gewindebolzens 6 kann beispielsweise aus einem Metall wie Aluminium und/oder Stahl und/oder ferritischer Stahl und/oder austenitischer Stahl und/oder Messing hergestellt sein. Der erste Hohlzylinder des ersten Gewindebolzens 6 kann ebenso aus einem Kunststoff hergestellt sein. Die vorstehenden Listen an Materialien des ersten Hohlzylinders des ersten Gewindebolzens 6 sind nicht abschliessend.

Die Gehäusewand 1 weist eine erste und eine zweite Seite auf. Die erste Seite der Gehäusewand 1 ist verschieden von der zweiten Seite der Gehäusewand 1. Die erste Seite der Gehäusewand 1 liegt der zweiten Seite der Gehäusewand 1 gegenüber. In einer Ausführungsform ist die erste Seite der Gehäusewand 1 parallel zur zweiten Seite der Gehäusewand 1.

Die erste Seite der Gehäusewand 1 gehört vorzugsweise zu einer Aussenseite des Gerätes, beispielsweise zu einer Aussenseite des elektrischen und/oder elektronischen Gerätes. Die zweite Seite der Gehäusewand 1 gehört vorzugsweise zu einer Innenseite des Gerätes, beispielsweise zu einer Innenseite des elektrischen und/oder elektronischen Gerätes.

An der ersten Seite der Gehäusewand 1 ist eine erste Schraubenmutter so an den ersten Gewindebolzen 6 angebracht, dass die erste Schraubenmutter an die erste Seite der Gehäusewand 1 grenzt. Vorzugsweise sind der Gewindebolzen 6 und die erste Schraubenmutter als ein einziges Teil, das heisst einstückig, ausgeführt. Die erste Schraubenmutter umfasst vorzugsweise eine erste Haltemutter und/oder eine erste Flachmutter. Die erste Schraubenmutter ist idealerweise eine erste Haltemutter und/oder eine erste Flachmutter. Die erste Schraubenmutter ist beispielsweise eine erste Schraubenmutter mit einem metrischen Gewinde an einer Innenseite der ersten Schraubenmutter. Vorzugsweise sind der Gewindebolzen 6 und die erste Haltemutter und/oder die erste Flachmutter als ein einziges Teil, das heisst einstückig, ausgeführt.

Die erste Schraubenmutter ist aus einem Material hergestellt, welches kompatibel ist mit dem Material des ersten Gewindebolzens 6. Die erste Schraubenmutter ist ebenso aus einem Material hergestellt, welches kompatibel ist mit dem Material der Gehäusewand 1. Die erste Schraubenmutter kann beispielsweise aus einem Metall wie Aluminium und/oder Stahl und/oder ferritischer Stahl und/oder austenitischer Stahl und/oder Messing hergestellt sein. Die erste Schraubenmutter kann ebenso aus einem Kunststoff hergestellt sein. Die vorstehenden Listen an Materialien der ersten Schraubenmutter sind nicht abschliessend.

An der zweiten Seite der Gehäusewand 1 ist eine zweite Schraubenmutter so an dem ersten Gewindebolzen 6 angebracht, dass die zweite Schraubenmutter an die zweite Seite der Gehäusewand 1 grenzt. Die zweite Schraubenmutter umfasst vorzugsweise eine zweite Haltemutter und/oder eine zweite Flachmutter. Die zweite Schraubenmutter ist idealerweise eine zweite Haltemutter und/oder eine zweite Flachmutter. Die zweite Schraubenmutter ist beispielsweise eine zweite Schraubenmutter mit einem metrischen Gewinde an einer Innenseite der zweiten Schraubenmutter.

Die zweite Schraubenmutter ist aus einem Material hergestellt, welches kompatibel ist mit dem Material des ersten Gewindebolzens 6. Die zweite Schraubenmutter ist ebenso aus einem Material hergestellt, welches kompatibel ist mit dem Material der Gehäusewand 1. Die zweite Schraubenmutter kann beispielsweise aus einem Metall wie Aluminium und/oder Stahl und/oder ferritischer Stahl und/oder austenitischer Stahl und/oder Messing hergestellt sein. Die zweite Schraubenmutter kann ebenso aus einem Kunststoff hergestellt sein. Die vorstehenden Listen an Materialien der zweiten Schraubenmutter sind nicht abschliessend.

Die zweite Schraubenmutter ist der ersten Schraubenmutter gegenüberliegend angeordnet. Zwischen der zweiten Schraubenmutter und der ersten Schraubenmutter ist die Gehäusewand 1 angeordnet. Die zweite Schraubenmutter und die erste Schraubenmutter befestigen den ersten Gewindebolzen 6 an der Gehäusewand 1. Die Befestigung ist derart, dass der erste Gewindebolzen 6 gegenüber der Gehäusewand 1 im Wesentlichen unbeweglich ist. Vorzugsweise befestigen die zweite Schraubenmutter und die erste Schraubenmutter den ersten Gewindebolzen 6 derart an der Gehäusewand 1, dass der erste Gewindebolzen 6 gegenüber der Gehäusewand 1 unbeweglich ist. Ein starrer Verbund ermöglicht eine exakte Positionierung der Bauteile, insbesondere eine exakte Positionierung elektrischer Kontakte zwischen den Bauteilen.

In einer Ausführungsform ist die zweite Haltemutter der ersten Haltemutter gegenüberliegend angeordnet. Zwischen der zweiten Haltemutter und der ersten Haltemutter ist die Gehäusewand 1 angeordnet. Die zweite Haltemutter und die erste Haltemutter befestigen den ersten Gewindebolzen 6 an der Gehäusewand 1. Die Befestigung ist derart, dass der erste Gewindebolzen 6 gegenüber der Gehäusewand 1 im Wesentlichen unbeweglich ist. Vorzugsweise befestigen die zweite Haltemutter und die erste Haltemutter den ersten Gewindebolzen 6 derart an der Gehäusewand 1, dass der erste Gewindebolzen 6 gegenüber der Gehäusewand 1 unbeweglich ist.

In einer weiteren Ausführungsform ist die zweite Flachmutter der ersten Flachmutter gegenüberliegend angeordnet. Zwischen der zweiten Flachmutter und der ersten Flachmutter ist die Gehäusewand 1 angeordnet. Die zweite Flachmutter und die erste Flachmutter befestigen den ersten Gewindebolzen 6 an der Gehäusewand 1. Die Befestigung ist derart, dass der erste Gewindebolzen 6 gegenüber der Gehäusewand 1 im Wesentlichen unbeweglich ist. Vorzugsweise befestigen die zweite Flachmutter und die erste Flachmutter den ersten Gewindebolzen 6 derart an der Gehäusewand 1, dass der erste Gewindebolzen 6 gegenüber der Gehäusewand 1 unbeweglich ist.

In einer speziellen Ausführungsform ist der erste Gewindebolzen 6 in die Gehäusewand 1 eingedreht. Das heisst, dass die erste Öffnung in der Gehäusewand 1 ein Innengewinde aufweist, welches zum ersten Aussengewinde des ersten Gewindebolzens 6 passt. Insbesondere können das Innengewinde der ersten Öffnung in der Gehäusewand 1 und das erste Aussengewinde des ersten Gewindebolzens 6 beide metrisch sein. In dieser Ausführungsform ist es möglich, dass die erste Schraubenmutter oder die zweite Schraubenmutter entfallen. Es können auch die erste Schraubenmutter und die zweite Schraubenmutter entfallen. Ebenso ist es möglich, dass die erste Haltemutter oder die zweite Haltemutter entfallen. Es können auch die erste Haltemutter und die zweite Haltemutter entfallen. Ferner ist es möglich, dass die erste Flachmutter oder die zweite Flachmutter entfallen. Es können auch erste Flachmutter und die zweite Flachmutter entfallen.

Vorzugsweise verläuft der erste Gewindebolzen 6 im Wesentlichen senkrecht zur ersten und zur zweiten Seite der Gehäusewand 1. Idealerweise verläuft der erste Gewindebolzen 6 senkrecht zur ersten und zur zweiten Seite der Gehäusewand 1.

An der zweiten Seite der Gehäusewand 1 ist ein Leiterplattenhalter 2 angeordnet. Vorzugsweise ist der Leiterplattenhalter 2 an der Innenseite des Gerätes, beispielsweise an der Innenseite des elektrischen und/oder elektronischen Gerätes angeordnet. Dabei können die zweite Seite der Gehäusewand 1 und der Leiterplattenhalter 2 beispielsweise zwei Millimeter oder einen Millimeter oder einen halben Millimeter beabstandet sein. Vorzugsweise ist der Abstand zwischen der zweiten Seite der Gehäusewand 1 und dem Leiterplattenhalter 2 gering oder sehr gering.

Der Leiterplattenhalter 2 kann beispielsweise aus einem Metall wie Aluminium und/oder Stahl und/oder ferritischer Stahl und/oder austenitischer Stahl hergestellt sein. Der Leiterplattenhalter 2 kann ebenso aus einem Kunststoff wie beispielsweise Polyvinylchlorid und/oder Polyethylenterephthalat und/oder Acrylnitril-Butadien-Styrol-Copolymer hergestellt sein. Die vorstehenden Listen an Materialien des Leiterplattenhalters 2 sind nicht abschliessend.

In einer Ausführungsform ist der Leiterplattenhalter 2 in einem Spritzgussverfahren hergestellt. Der Leiterplattenhalter 2 oder Teile des Leiterplattenhalters 2 werden nach einem Aspekt der vorliegenden Offenbarung mit einem additiven Herstellungsverfahren wie dem dreidimensionalen Druck hergestellt. Die Herstellung des Leiterplattenhalters 2 und/oder von Teilen des Leiterplattenhalters 2 kann in einer speziellen Ausführungsform durch selektives Lasersintern erfolgen.

Der Leiterplattenhalter 2 weist eine erste Seite und eine zweite Seite auf. Die erste Seite des Leiterplattenhalters 2 ist verschieden von der zweiten Seite des Leiterplattenhalters 2. Die erste Seite des Leiterplattenhalters 2 liegt der zweiten Seite des Leiterplattenhalters 2 gegenüber. In einer Ausführungsform ist die erste Seite des Leiterplattenhalters 2 parallel zur zweiten Seite des Leiterplattenhalters 2.

Vorzugsweise liegt die erste Seite des Leiterplattenhalters 2 der zweiten Seite der Gehäusewand 1 gegenüber. Idealerweise sind die erste Seite des Leiterplattenhalters 2 und die zweite Seite der Gehäusewand 1 im Wesentlichen parallel angeordnet. Insbesondere können die erste Seite des Leiterplattenhalters 2 und die zweite Seite der Gehäusewand 1 parallel angeordnet sein. Ferner können die erste Seite des Leiterplattenhalters 2 und die erste Seite der Gehäusewand 1 parallel angeordnet sein. Ausserdem können die zweite Seite des Leiterplattenhalters 2 und die zweite Seite der Gehäusewand 1 parallel angeordnet sein. Darüber hinaus können die zweite Seite des Leiterplattenhalters 2 und die erste Seite der Gehäusewand 1 parallel angeordnet sein.

Der Leiterplattenhalter 2 weist eine erste Öffnung auf. Die erste Öffnung in dem Leiterplattenhalter 2 hat vorzugsweise einen kreisförmigen Querschnitt. Die erste Öffnung in dem Leiterplattenhalter 2 kann weiterhin einen quadratischen, rechteckigen oder sechseckigen Querschnitt aufweisen. Die vorstehende Aufzählung von Querschnitten der ersten Öffnung in dem Leiterplattenhalter 2 erhebt keinen Anspruch auf Vollständigkeit.

In einer Ausführungsform ist die erste Öffnung in dem Leiterplattenhalter 2 eine Bohrung. In einer weiteren Ausführungsform ist die erste Öffnung in dem Leiterplattenhalter 2 gestanzt. Weitere technische Möglichkeiten zum Herstellen der ersten Öffnung in dem Leiterplattenhalter 2 sind einschlägig bekannt. Beispielsweise kann die erste Öffnung in dem Leiterplattenhalter 2 im Rahmen der Herstellung mit einem additiven Herstellungsverfahren als Aussparung angebracht sein.

Durch die erste Öffnung in dem Leiterplattenhalter 2 ist der erste Gewindebolzen 6 geführt. Der erste Gewindebolzen 6 umfasst im Bereich des Leiterplattenhalters 2 vorzugsweise einen ersten Hohlzylinder mit einem ersten Aussengewinde, beispielsweise mit einem ersten metrischen Aussengewinde. Der erste Gewindebolzen 6 ist im Bereich des Leiterplattenhalters 2 idealerweise ein erster Hohlzylinder mit einem ersten Aussengewinde, beispielsweise mit einem ersten metrischen Aussengewinde.

Vorzugsweise verläuft der erste Gewindebolzen 6 im Wesentlichen senkrecht zur ersten und zur zweiten Seite des Leiterplattenhalters 2. Idealerweise verläuft der erste Gewindebolzen 6 senkrecht zur ersten und zur zweiten Seite des Leiterplattenhalters 2.

Zwischen dem Leiterplattenhalter 2 und der Gehäusewand 1 ist ein erster Abstandshalter eingefügt. Vorzugsweise ist zwischen dem Leiterplattenhalter 2 und der zweiten Seite der Gehäusewand 1 ein erster Abstandshalter eingefügt. Idealerweise verläuft ein Abschnitt des ersten Gewindebolzens 6 innerhalb des ersten Abstandshalters.

Der erste Abstandshalter ist aus einem Material hergestellt, welches kompatibel mit dem Material des ersten Gewindebolzens 6 und mit der Gehäusewand 1 ist. Der erste Abstandshalter ist ebenso aus einem Material hergestellt, welches kompatibel ist mit dem Material des Leiterplattenhalters 2. Ferner ist der erste Abstandshalter ebenso aus einem Material hergestellt, welches kompatibel ist mit dem Material der zweiten Schraubenmutter, insbesondere der zweiten Haltemutter und/oder der zweiten Flachmutter.

Der erste Abstandshalter kann beispielsweise aus einem Metall wie Aluminium und/oder Stahl und/oder ferritischer Stahl und/oder austenitischer Stahl und/oder Messing hergestellt sein. Der erste Abstandshalter kann ebenso aus einem Kunststoff hergestellt sein. Die vorstehenden Listen an Materialien des ersten Abstandshalters sind nicht abschliessend.

Der erste Abstandshalter hat eine Längendimension, welche parallel zum ersten Gewindebolzen 6 ist. Insbesondere ist die Längendimension des ersten Abstandshalters parallel zu einer Achse des ersten Gewindebolzens 6, wobei der erste Gewindebolzen 6 um jene Achse im Wesentlichen zylindersymmetrisch ist. In einer Ausführungsform 6 ist der erste Gewindebolzen 6 bis auf sein erstes Aussengewinde zylindersymmetrisch zu jener Achse des ersten Gewindebolzens 6.

Die Längendimension des ersten Abstandshalters kann beispielsweise mehr als einen Millimeter oder mehr als zwei Millimeter oder mehr als fünf Millimeter betragen. Ein ausreichender Abstand des Leiterplattenhalters 2 von der Gehäusewand 1 trägt zur elektrischen und/oder thermischen Isolierung beider Bauteile bei. Ein ausreichender Abstand des Leiterplattenhalters 2 von der zweiten Seite der Gehäusewand 1 trägt zur elektrischen und/oder thermischen Isolierung beider Bauteile bei.

Der erste Abstandshalter weist eine erste Seite auf. Die erste Seite des ersten Abstandshalters grenzt vorzugsweise an die zweite Schraubenmutter. Die erste Seite des ersten Abstandshalters grenzt vorzugsweise an die zweite Haltemutter. In einer weiteren Ausführungsform grenzt die erste Seite des ersten Abstandshalters an die zweite Flachmutter.

Der erste Abstandshalter weist eine zweite Seite auf. Die zweite Seite des ersten Abstandshalters ist verschieden von der ersten Seite des ersten Abstandshalters. Vorzugsweise sind die erste und die zweite Seite des ersten Abstandshalters parallel zueinander.

Die Längendimension des ersten Abstandshalters entspricht einem kürzesten Abstand zwischen der ersten und der zweiten Seite des ersten Abstandshalters. Die Längendimension ist idealerweise ein kürzester Abstand zwischen der ersten und der zweiten Seite des ersten Abstandshalters.

Die zweite Seite des ersten Abstandshalters grenzt an den Leiterplattenhalter 2. Insbesondere grenzt die zweite Seite des ersten Abstandshalters an die erste Seite des Leiterplattenhalters 2. In einer Ausführungsform liegt die zweite Seite des ersten Abstandshalters auf der ersten Seite des Leiterplattenhalters 2 auf.

An der zweiten Seite des Leiterplattenhalters 2 ist eine dritte Schraubenmutter 3 so an den ersten Gewindebolzen 6 angebracht, dass die dritte Schraubenmutter 3 an die zweite Seite des Leiterplattenhalters 2 grenzt. Die dritte Schraubenmutter 3 umfasst vorzugsweise eine dritte Haltemutter und/oder eine dritte Flachmutter. Die dritte Schraubenmutter 3 ist idealerweise eine dritte Haltemutter und/oder eine dritte Flachmutter. Die dritte Schraubenmutter 3 ist beispielsweise eine dritte Schraubenmutter 3 mit einem metrischen Gewinde an einer Innenseite der dritten Schraubenmutter 3.

Die dritte Schraubenmutter 3 ist aus einem Material hergestellt, welches kompatibel ist mit dem Material des ersten Gewindebolzens 6. Die dritte Schraubenmutter 3 ist ebenso aus einem Material hergestellt, welches kompatibel ist mit dem Material des Leiterplattenhalters 2. Die dritte Schraubenmutter 3 kann beispielsweise aus einem Metall wie Aluminium und/oder Stahl und/oder ferritischer Stahl und/oder austenitischer Stahl und/oder Messing hergestellt sein. Die dritte Schraubenmutter 3 kann ebenso aus einem Kunststoff hergestellt sein. Die vorstehenden Listen an Materialien der dritten Schraubenmutter 3 sind nicht abschliessend.

Die dritte Schraubenmutter 3 ist dem ersten Abstandshalter gegenüberliegend angeordnet. Zwischen der dritten Schraubenmutter 3 und dem ersten Abstandshalter ist der Leiterplattenhalter 2 angeordnet. Die dritte Schraubenmutter 3 und der erste Abstandshalter befestigen den ersten Gewindebolzen 6 an dem Leiterplattenhalter 2. Die Befestigung ist derart, dass der erste Gewindebolzen 6 gegenüber dem Leiterplattenhalter 2 im Wesentlichen unbeweglich ist. Vorzugsweise befestigen die dritte Schraubenmutter 3 und der erste Abstandshalter den ersten Gewindebolzen 6 derart an dem Leiterplattenhalter 2, dass der erste Gewindebolzen 6 gegenüber dem Leiterplattenhalter 2 unbeweglich ist.

In einer Ausführungsform ist die dritte Haltemutter und/oder dritte Flachmutter dem ersten Abstandshalter gegenüberliegend angeordnet. Zwischen der dritten Haltemutter und/oder der dritten Flachmutter und dem ersten Abstandshalter ist der Leiterplattenhalter 2 angeordnet. Die dritte Haltemutter und/oder dritte Flachmutter und der erste Abstandshalter befestigen den ersten Gewindebolzen 6 an dem Leiterplattenhalter 2. Die Befestigung ist derart, dass der erste Gewindebolzen 6 gegenüber dem Leiterplattenhalter 2 im Wesentlichen unbeweglich ist. Vorzugsweise ist die Befestigung derart, dass der erste Gewindebolzen 6 gegenüber dem Leiterplattenhalter 2 unbeweglich ist.

In einer speziellen Ausführungsform ist der erste Gewindebolzen 6 in den Leiterplattenhalter 2 eingedreht. Das heisst, dass die erste Öffnung in dem Leiterplattenhalter 2 ein Innengewinde aufweist, welches zum ersten Aussengewinde des ersten Gewindebolzens 6 passt. Insbesondere können das Innengewinde der ersten Öffnung in dem Leiterplattenhalter 2 und das erste Aussengewinde des ersten Gewindebolzens 6 beide metrisch sein. In dieser Ausführungsform ist es möglich, dass die dritte Schraubenmutter 3 oder der erste Abstandshalter entfallen. Es können auch die dritte Schraubenmutter 3 und der erste Abstandshalter entfallen. Ebenso ist es möglich, dass die dritte Haltemutter oder der erste Abstandshalter entfallen. Es können auch die dritte Haltemutter und der erste Abstandshalter entfallen. Ferner ist es möglich, dass die dritte Flachmutter oder der erste Abstandshalter entfallen. Es können auch die dritte Flachmutter und der erste Abstandshalter entfallen.

Gemäss einem Aspekt der vorliegenden Offenbarung ist der erste Gewindebolzen 6 die einzige mechanische Verbindung zwischen Leiterplattenhalter 2 und Gehäusewand 1. Insbesondere ist der erste Gewindebolzen 6 die einzige mechanische Verbindung zwischen der ersten Seite des Leiterplattenhalters 2 und der zweiten Seite der Gehäusewand 1.

Gemäss einem anderen Aspekt der vorliegenden Offenbarung ist der erste Gewindebolzen 6 nicht die einzige mechanische Verbindung zwischen Leiterplattenhalter 2 und Gehäusewand 1. Insbesondere ist der erste Gewindebolzen 6 nicht die einzige mechanische Verbindung zwischen der ersten Seite des Leiterplattenhalters 2 und der zweiten Seite der Gehäusewand 1. Beispielsweise kann sich zwischen Leiterplattenhalter 2 und Gehäusewand 1 mindestens eine mechanische Stütze befinden. Insbesondere kann sich zwischen der ersten Seite des Leiterplattenhalters 2 und der zweiten Seite der Gehäusewand 1 mindestens eine mechanische Stütze befinden.

Die mindestens eine mechanische Stütze ist vorzugsweise dicker als die Längendimension des ersten Abstandshalters. Dabei bemisst sich die Dicke der mindestens einen mechanischen Stütze zwischen einer ersten und einer zweiten Seite der mindestens einen mechanischen Stütze. Die erste Seite der mindestens einen mechanischen Stütze ist verschieden von der zweiten Seite der mindestens einen mechanischen Stütze. Die erste Seite der mindestens einen mechanischen Stütze grenzt an die zweite Seite der Gehäusewand 1. Die zweite Seite der mindestens einen mechanischen Stütze grenzt an den Leiterplattenhalter 2. Die Dicke der mindestens einen mechanischen Stütze kann beispielsweise mehr als zwei Millimeter oder mehr als drei Millimeter oder mehr als sechs Millimeter betragen.

Ausserdem kann anstelle des ersten Abstandshalters eine vierte Schraubenmutter so angebracht sein, dass sie an die erste Seite des Leiterplattenhalters 2 grenzt. Der Leiterplattenhalter 2 liegt zwischen der dritten Schraubenmutter 3 auf der zweiten Seite des Leiterplattenhalters 2 und der vierten Schraubenmutter auf der ersten Seite des Leiterplattenhalters 2. Die dritte Schraubenmutter 3 und die vierte Schraubenmutter befestigen den ersten Gewindebolzen 6 an dem Leiterplattenhalter 2. Die Befestigung ist derart, dass der erste Gewindebolzen 6 gegenüber dem Leiterplattenhalter 2 im Wesentlichen unbeweglich ist. Vorzugsweise befestigen die dritte Schraubenmutter 3 und die vierte Schraubenmutter den ersten Gewindebolzen 6 derart an dem Leiterplattenhalter 2, dass der erste Gewindebolzen 6 gegenüber dem Leiterplattenhalter 2 unbeweglich ist. Ein starrer Verbund ermöglicht eine exakte Positionierung der Bauteile, insbesondere eine exakte Positionierung elektrischer Kontakte zwischen den Bauteilen.

Die vierte Schraubenmutter kann eine vierte Haltemutter umfassen. Insbesondere kann die vierte Schraubenmutter eine vierte Haltemutter sein. In einer Ausführungsform ist die dritte Haltemutter der vierten Haltemutter gegenüberliegend angeordnet. Zwischen der dritten Haltemutter und der vierten Haltemutter ist der Leiterplattenhalter 2 angeordnet. Die dritte Haltemutter und die vierte Haltemutter befestigen den ersten Gewindebolzen 6 an dem Leiterplattenhalter 2. Die Befestigung ist derart, dass der erste Gewindebolzen 6 gegenüber dem Leiterplattenhalter 2 im Wesentlichen unbeweglich ist. Vorzugsweise ist die Befestigung derart, dass der erste Gewindebolzen 6 gegenüber dem Leiterplattenhalter 2 unbeweglich ist.

Die vierte Schraubenmutter kann eine vierte Flachmutter umfassen. Insbesondere kann die vierte Schraubenmutter eine vierte Flachmutter sein. In einer Ausführungsform ist die dritte Flachmutter der vierten Flachmutter gegenüberliegend angeordnet. Zwischen der dritten Flachmutter und der vierten Flachmutter ist der Leiterplattenhalter 2 angeordnet. Die dritte Flachmutter und die vierte Flachmutter befestigen den ersten Gewindebolzen 6 an dem Leiterplattenhalter 2. Die Befestigung ist derart, dass der erste Gewindebolzen 6 gegenüber dem Leiterplattenhalter 2 im Wesentlichen unbeweglich ist. Vorzugsweise ist die Befestigung derart, dass der erste Gewindebolzen 6 gegenüber dem Leiterplattenhalter 2 unbeweglich ist.

Der Leiterplattenhalter 2 kann einen oder mehrere Holme aufweisen. Der eine oder die mehreren Holme stehen von der zweiten Seite des Leiterplattenhalters 2 ab. FIG 1 zeigt einen Leiterplattenhalter 2 mit zwei Holmen. Die beiden Holme stehen von der zweiten Seite des Leiterplattenhalters 2 ab. In einer Ausführungsform kann der Leiterplattenhalter 2 auch drei oder mehr Holme umfassen, welche von der zweiten Seite des Leiterplattenhalters 2 abstehen.

Der eine oder die mehreren Holme verbinden den Leiterplattenhalter 2 mit einer Leiterplatte 4. Dazu können der eine oder die mehreren Holme eine jeweils eine zylindrische Vertiefung mit Innengewinde aufweisen. Das Innengewinde oder die Innengewinde können metrische Innengewinde sein.

Jeweils eine Schraube sichert die Leiterplatte 4 an dem jeweiligen Holm. Die Schraube oder die Schrauben können metrische Schrauben sein. In einer verschraubten Ausführungsform mit einem Holm ist die Leiterplatte 4 zwischen dem Holm und der Schraube angeordnet. Das heisst, dass die Leiterplatte 4 eine erste und eine zweite Seite aufweist. Die erste Seite der Leiterplatte 4 ist verschieden von der zweiten Seite der Leiterplatte 4. Die erste Seite der Leiterplatte 4 liegt der zweiten Seite der Leiterplatte 4 gegenüber. In einer Ausführungsform ist die erste Seite der Leiterplatte 4 parallel zur zweiten Seite der Leiterplatte 4. Die erste Seite der Leiterplatte 4 grenzt an den Holm. Die zweite Seite der Leiterplatte 4 grenzt an die Schraube.

Vorzugsweise verläuft der Holm im Wesentlichen senkrecht zur ersten und zur zweiten Seite des Leiterplattenhalters 2. Idealerweise verläuft der Holm senkrecht zur ersten und zur zweiten Seite des Leiterplattenhalters 2.

Vorzugsweise verläuft der Holm im Wesentlichen senkrecht zur ersten und zur zweiten Seite der Leiterplatte 4. Idealerweise verläuft der Holm senkrecht zur ersten und zur zweiten Seite der Leiterplatte 4.

In einer verschraubten Ausführungsform mit mehreren Holmen ist die Leiterplatte 4 zwischen den Holmen und den jeweiligen Schrauben angeordnet. Das heisst, dass die Leiterplatte 4 eine erste und eine zweite Seite aufweist. Die erste Seite der Leiterplatte 4 ist verschieden von der zweiten Seite der Leiterplatte 4. Die erste Seite der Leiterplatte 4 liegt der zweiten Seite der Leiterplatte 4 gegenüber. In einer Ausführungsform ist die erste Seite der Leiterplatte 4 parallel zur zweiten Seite der Leiterplatte 4. Die erste Seite der Leiterplatte 4 grenzt an die Holme. Die zweite Seite der Leiterplatte 4 grenzt an die Schrauben.

Vorzugsweise verlaufen die Holme im Wesentlichen senkrecht zur ersten und zur zweiten Seite des Leiterplattenhalters 2. Idealerweise verlaufen die Holme senkrecht zur ersten und zur zweiten Seite des Leiterplattenhalters 2.

Vorzugsweise verlaufen die Holme im Wesentlichen senkrecht zur ersten und zur zweiten Seite der Leiterplatte 4. Idealerweise verlaufen die Holme senkrecht zur ersten und zur zweiten Seite der Leiterplatte 4.

Gemäss einem weiteren Aspekt der vorliegenden Offenbarung weisen der oder die Holme jeweils eine Vertiefung an deren jeweiligem Ende auf. Es sichert jeweils eine Niet die Leiterplatte 4 an dem jeweiligen Holm. In einer vernieteten Ausführungsform mit einem Holm ist die Leiterplatte 4 zwischen dem Holm und der Niet angeordnet. Das heisst, dass die Leiterplatte 4 eine erste und eine zweite Seite aufweist. Die erste Seite der Leiterplatte 4 ist verschieden von der zweiten Seite der Leiterplatte 4. Die erste Seite der Leiterplatte 4 liegt der zweiten Seite der Leiterplatte 4 gegenüber. In einer Ausführungsform ist die erste Seite der Leiterplatte 4 parallel zur zweiten Seite der Leiterplatte 4. Die erste Seite der Leiterplatte 4 grenzt an den Holm. Die zweite Seite der Leiterplatte 4 grenzt an die Niet.

Vorzugsweise verläuft der Holm im Wesentlichen senkrecht zur ersten und zur zweiten Seite des Leiterplattenhalters 2. Idealerweise verläuft der Holm senkrecht zur ersten und zur zweiten Seite des Leiterplattenhalters 2.

Vorzugsweise verläuft der Holm im Wesentlichen senkrecht zur ersten und zur zweiten Seite der Leiterplatte 4. Idealerweise verläuft der Holm senkrecht zur ersten und zur zweiten Seite der Leiterplatte 4.

In einer vernieteten Ausführungsform mit mehreren Holmen ist die Leiterplatte 4 zwischen den Holmen und den jeweiligen Niete angeordnet. Das heisst, dass die Leiterplatte 4 eine erste und eine zweite Seite aufweist. Die erste Seite der Leiterplatte 4 ist verschieden von der zweiten Seite der Leiterplatte 4. Die erste Seite der Leiterplatte 4 liegt der zweiten Seite der Leiterplatte 4 gegenüber. In einer Ausführungsform ist die erste Seite der Leiterplatte 4 parallel zur zweiten Seite der Leiterplatte 4. Die erste Seite der Leiterplatte 4 grenzt an die Holme. Die zweite Seite der Leiterplatte 4 grenzt an die Niete.

Vorzugsweise verlaufen die Holme im Wesentlichen senkrecht zur ersten und zur zweiten Seite des Leiterplattenhalters 2. Idealerweise verlaufen die Holme senkrecht zur ersten und zur zweiten Seite des Leiterplattenhalters 2.

Vorzugsweise verlaufen die Holme im Wesentlichen senkrecht zur ersten und zur zweiten Seite der Leiterplatte 4. Idealerweise verlaufen die Holme senkrecht zur ersten und zur zweiten Seite der Leiterplatte 4.

Gemäss noch einem weiteren Aspekt der vorliegenden Offenbarung sichert jeweils eine Klebstelle die Leiterplatte 4 an dem jeweiligen Holm. Das heisst, dass die Leiterplatte 4 eine erste und eine zweite Seite aufweist. Die erste Seite der Leiterplatte 4 ist verschieden von der zweiten Seite der Leiterplatte 4. Die erste Seite der Leiterplatte 4 liegt der zweiten Seite der Leiterplatte 4 gegenüber. In einer Ausführungsform ist die erste Seite der Leiterplatte 4 parallel zur zweiten Seite der Leiterplatte 4. Die erste Seite der Leiterplatte 4 grenzt an den Holm und an die Klebstelle.

Vorzugsweise verläuft der Holm im Wesentlichen senkrecht zur ersten und zur zweiten Seite des Leiterplattenhalters 2. Idealerweise verläuft der Holm senkrecht zur ersten und zur zweiten Seite des Leiterplattenhalters 2.

Vorzugsweise verläuft der Holm im Wesentlichen senkrecht zur ersten und zur zweiten Seite der Leiterplatte 4. Idealerweise verläuft der Holm senkrecht zur ersten und zur zweiten Seite der Leiterplatte 4.

In einer verklebten Ausführungsform mit mehreren Holmen weist die Leiterplatte 4 wiederum eine erste und eine zweite Seite auf. Die erste Seite der Leiterplatte 4 ist verschieden von der zweiten Seite der Leiterplatte 4. Die erste Seite der Leiterplatte 4 liegt der zweiten Seite der Leiterplatte 4 gegenüber. In einer Ausführungsform ist die erste Seite der Leiterplatte 4 parallel zur zweiten Seite der Leiterplatte 4. Die erste Seite der Leiterplatte 4 grenzt an die Holme und an die Klebstellen.

Vorzugsweise verlaufen die Holme im Wesentlichen senkrecht zur ersten und zur zweiten Seite des Leiterplattenhalters 2. Idealerweise verlaufen die Holme senkrecht zur ersten und zur zweiten Seite des Leiterplattenhalters 2.

Vorzugsweise verlaufen die Holme im Wesentlichen senkrecht zur ersten und zur zweiten Seite der Leiterplatte 4. Idealerweise verlaufen die Holme senkrecht zur ersten und zur zweiten Seite der Leiterplatte 4.

Unabhängig von der Realisierung der Befestigung der Leiterplatte 4 ist der Leiterplattenhalter 2 gegenüber der Leiterplatte 4 im Wesentlichen unbeweglich. Vorzugsweise ist der Leiterplattenhalter 2 gegenüber der Leiterplatte 4 unbeweglich. Unabhängig von der Realisierung der Befestigung der Leiterplatte 4 ist die Gehäusewand 1 gegenüber der Leiterplatte 4 im Wesentlichen unbeweglich. Vorzugsweise ist die Gehäusewand 1 gegenüber der Leiterplatte 4 unbeweglich. Unabhängig von der Realisierung der Befestigung der Leiterplatte 4 ist der erste Gewindebolzen 6 gegenüber der Leiterplatte 4 im Wesentlichen unbeweglich. Vorzugsweise ist der erste Gewindebolzen 6 gegenüber der Leiterplatte 4 unbeweglich. Ein starrer Verbund ermöglicht eine exakte Positionierung der Bauteile, insbesondere eine exakte Positionierung elektrischer Kontakte zwischen den Bauteilen.

Unabhängig von der Realisierung der Befestigung der Leiterplatte 4 hat der Holm oder haben die Holme eine Längendimension. In Ausführungsformen mit genau einem Holm hat der Holm eine Längendimension. Ein erstes Ende des Holmes befindet sich an der Schnittfläche zwischen der zweiten Seite des Leiterplattenhalters 2 und dem Holm. Ein zweites Ende des Holmes ist in Richtung erste Seite der Leiterplatte 4 gerichtet. Das erste Ende des Holmes ist verschieden vom zweiten Ende des Holmes.

Die Längendimension des Holmes zwischen dem ersten und dem zweiten Ende des Holmes ist vorzugsweise grösser als drei Millimeter. Die Längendimension des Holmes zwischen dem ersten und dem zweiten Ende des Holmes kann auch grösser als sechs Millimeter sein. Schliesslich kann die Längendimension des Holmes zwischen dem ersten und dem zweiten Ende des Holmes auch länger als zwölf Millimeter sein.

In Ausführungsformen mit mehreren Holmen haben die Holme jeweils eine Längendimension. Ein erstes Ende jedes Holmes befindet sich an der Schnittfläche zwischen der zweiten Seite des Leiterplattenhalters 2 und dem jeweiligen Holm. Ein zweites Ende jedes Holmes ist in Richtung erste Seite der Leiterplatte 4 gerichtet. Bei jedem Holm ist das erste Ende des Holmes verschieden vom zweiten Ende des Holmes.

Die Längendimension jedes Holmes zwischen dem ersten und dem zweiten Ende des jeweiligen Holmes ist vorzugsweise grösser als drei Millimeter. Die Längendimension jedes Holmes zwischen dem ersten und dem zweiten Ende des jeweiligen Holmes kann auch grösser als sechs Millimeter sein. Schliesslich kann die Längendimension jedes Holmes zwischen dem ersten und dem zweiten Ende des jeweiligen Holmes auch länger als zwölf Millimeter sein.

Gemäss einem Aspekt der Ausführungsform mit mehreren Holmen sind alle Holme gleich lang. Das heisst, dass alle Holme im Wesentlichen die gleiche Längendimension zwischen deren jeweiligen ersten und zweiten Enden aufweisen. Insbesondere können alle Holme die gleiche Längendimension zwischen deren jeweiligen ersten und zweiten Enden aufweisen. Mithin entfallen Anpassungen an unterschiedliche Längendimensionen der Holme.

Vorzugsweise sind der Leiterplattenhalter 2 und der Holm oder die Holme aus einem Stück gefertigt. Das heisst, dass kein Holm und keine Holme nachträglich an den Leiterplattenhalter 2 angebracht werden müssen. In einer Ausführungsform sind der Leiterplattenhalter 2 und der Holm oder die Holme einstückig in einem Spritzgussverfahren hergestellt. Der Leiterplattenhalter 2 und der oder die Holme werden nach einem Aspekt der vorliegenden Offenbarung mit einem additiven Herstellungsverfahren wie dem dreidimensionalen Druck einstückig hergestellt. Die einstückige Herstellung des Leiterplattenhalters 2 und des Holmes oder der Holme kann in einer speziellen Ausführungsform durch selektives Lasersintern erfolgen.

Ein ausreichender Abstand der Leiterplatte 4 von dem Leiterplattenhalter 2 und von der Gehäusewand 1 schützt die Bauteile auf der Leiterplatte 4 zusätzlich vor Einwirkungen von aussen.

Die Leiterplatte 4 kann beispielsweise aus einem Kunststoff wie laminiertem Epoxidharz und/oder laminierten Polyimiden und/oder laminiertem Polytetrafluorethylen hergestellt sein. Die Leiterplatte 4 kann ebenso aus einer Kombination der vorgenannten Polymere hergestellt sein. Die vorstehenden Listen an Materialien der Leiterplatte 4 sind nicht abschliessend. Vorzugsweise ist die Leiterplatte 4 etwa 1.6 Millimeter dick. Die Dicke der Leiterplatte 4 bezieht sich auf einen kürzesten Abstand zwischen der ersten und der zweiten Seite der Leiterplatte 4.

Eine Leiterplatte 4 gemäss Standardabmessungen reduziert Anpassungen der Lösung an Nichtstandardbauteile. Die Komplexität der Lösung wird dadurch verringert.

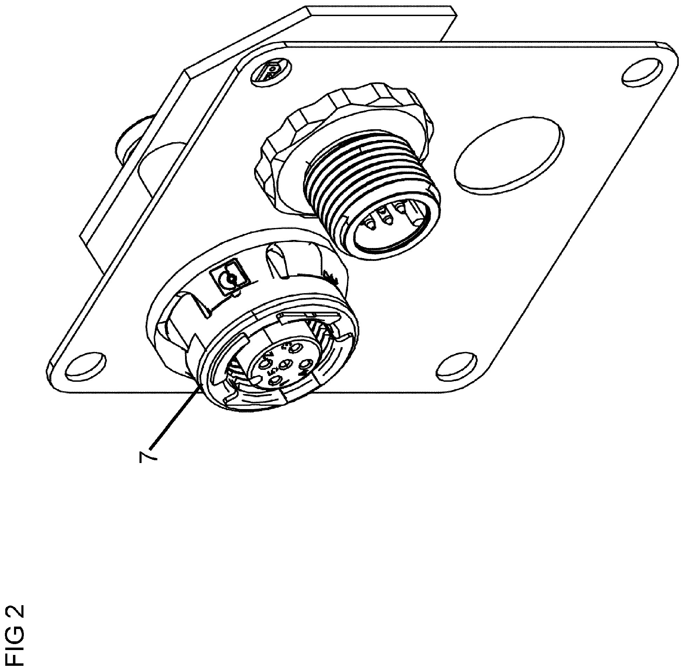

FIG 2 zeigt einen zweiten Gewindebolzen 7. Der zweite Gewindebolzen 7 ist optional. Der zweite Gewindebolzen 7 ist verschieden vom ersten Gewindebolzen 6.

Der zweite Gewindebolzen 7 umfasst vorzugsweise einen zweiten Hohlzylinder mit einem zweiten Aussengewinde, beispielsweise mit einem zweiten metrischen Aussengewinde. Der zweite Gewindebolzen 7 ist idealerweise ein zweiter Hohlzylinder mit einem zweiten Aussengewinde, beispielsweise mit einem zweiten metrischen Aussengewinde.

Vorzugsweise weisen der erste Gewindebolzen 6 und der zweite Gewindebolzen 7 die gleichen Typen von Aussengewinden auf. Idealerweise weisen der erste Gewindebolzen 6 und der zweite Gewindebolzen 7 jeweils metrische Aussengewinde auf. Gleiche Typen von Aussengewinden ermöglichen einen hohen Anteil gleicher Teile. Mithin vermindert sich die Komplexität der Lösung.

Im Falle des Vorhandenseins eines zweiten Gewindebolzens 7 weist die Gehäusewand 1 eine zweite Öffnung auf. Die zweite Öffnung in der Gehäusewand 1 hat vorzugsweise einen kreisförmigen Querschnitt. Die zweite Öffnung in der Gehäusewand 1 kann weiterhin einen quadratischen, rechteckigen oder sechseckigen Querschnitt aufweisen. Die vorstehende Aufzählung von Querschnitten der zweiten Öffnung in der Gehäusewand 1 erhebt keinen Anspruch auf Vollständigkeit.

In einer Ausführungsform ist die zweite Öffnung in der Gehäusewand 1 eine Bohrung. In einer weiteren Ausführungsform ist die zweite Öffnung in der Gehäusewand 1 gestanzt.

Weitere technische Möglichkeiten zum Herstellen der zweiten Öffnung in der Gehäusewand 1 sind einschlägig bekannt. Beispielsweise kann die zweite Öffnung in der Gehäusewand 1 im Rahmen der Herstellung mit einem additiven Herstellungsverfahren als Aussparung angebracht sein.

Durch die zweite Öffnung in der Gehäusewand 1 ist ein zweiter Gewindebolzen 7 geführt. Der zweite Gewindebolzen 7 umfasst vorzugsweise einen zweiten Hohlzylinder mit einem zweiten Aussengewinde, beispielsweise mit einem zweiten metrischen Aussengewinde. Der zweite Gewindebolzen 7 ist idealerweise ein zweiter Hohlzylinder mit einem zweiten Aussengewinde, beispielsweise mit einem zweiten metrischen Aussengewinde.

Der zweite Hohlzylinder des zweiten Gewindebolzens 7 ist aus einem Material gefertigt, welches kompatibel ist mit dem Material der Gehäusewand 1. Der zweite Hohlzylinder des zweiten Gewindebolzens 7 kann beispielsweise aus einem Metall wie Aluminium und/oder Stahl und/oder ferritischer Stahl und/oder austenitischer Stahl und/oder Messing hergestellt sein. Der zweite Hohlzylinder des zweiten Gewindebolzens 7 kann ebenso aus einem Kunststoff hergestellt sein. Die vorstehenden Listen an Materialien des zweiten Hohlzylinders des zweiten Gewindebolzens 7 sind nicht abschliessend.

An der ersten Seite der Gehäusewand 1 ist eine fünfte Schraubenmutter so an den zweiten Gewindebolzen 7 angebracht, dass die fünfte Schraubenmutter an die erste Seite der Gehäusewand 1 grenzt. Die fünfte Schraubenmutter umfasst vorzugsweise eine fünfte Haltemutter und/oder eine fünfte Flachmutter. Die fünfte Schraubenmutter ist idealerweise eine fünfte Haltemutter und/oder eine fünfte Flachmutter. Die fünfte Schraubenmutter ist beispielsweise eine fünfte Schraubenmutter mit einem metrischen Gewinde an einer Innenseite der fünften Schraubenmutter.

Die fünfte Schraubenmutter ist aus einem Material hergestellt, welches kompatibel ist mit dem Material des zweiten Gewindebolzens 7. Die fünfte Schraubenmutter ist ebenso aus einem Material hergestellt, welches kompatibel ist mit dem Material der Gehäusewand 1. Die fünfte Schraubenmutter kann beispielsweise aus einem Metall wie Aluminium und/oder Stahl und/oder ferritischer Stahl und/oder austenitischer Stahl und/oder Messing hergestellt sein. Die fünfte Schraubenmutter kann ebenso aus einem Kunststoff hergestellt sein. Die vorstehenden Listen an Materialien der fünften Schraubenmutter sind nicht abschliessend.

An der zweiten Seite der Gehäusewand 1 ist eine sechste Schraubenmutter so an dem zweiten Gewindebolzen 7 angebracht, dass die sechste Schraubenmutter an die zweite Seite der Gehäusewand 1 grenzt. Die sechste Schraubenmutter umfasst vorzugsweise eine sechste Haltemutter und/oder eine sechste Flachmutter. Die sechste Schraubenmutter ist idealerweise eine sechste Haltemutter und/oder eine sechste Flachmutter. Die sechste Schraubenmutter ist beispielsweise eine sechste Schraubenmutter mit einem metrischen Gewinde an einer Innenseite der sechsten Schraubenmutter.

Die sechste Schraubenmutter ist aus einem Material hergestellt, welches kompatibel ist mit dem Material des zweiten Gewindebolzens 7. Die sechste Schraubenmutter ist ebenso aus einem Material hergestellt, welches kompatibel ist mit dem Material der Gehäusewand 1. Die sechste Schraubenmutter kann beispielsweise aus einem Metall wie Aluminium und/oder Stahl und/oder ferritischer Stahl und/oder austenitischer Stahl und/oder Messing hergestellt sein. Die sechste Schraubenmutter kann ebenso aus einem Kunststoff hergestellt sein. Die vorstehenden Listen an Materialien der sechsten Schraubenmutter sind nicht abschliessend.

Die sechste Schraubenmutter ist der fünften Schraubenmutter gegenüberliegend angeordnet. Zwischen der sechsten Schraubenmutter und der fünften Schraubenmutter ist die Gehäusewand 1 angeordnet. Die sechste Schraubenmutter und die fünfte Schraubenmutter befestigen den zweiten Gewindebolzen 7 an der Gehäusewand 1. Die Befestigung ist derart, dass der zweite Gewindebolzen 7 gegenüber der Gehäusewand 1 im Wesentlichen unbeweglich ist. Vorzugsweise befestigen die sechste Schraubenmutter und die fünfte Schraubenmutter den zweiten Gewindebolzen 7 derart an der Gehäusewand 1, dass der zweite Gewindebolzen 7 gegenüber der Gehäusewand 1 unbeweglich ist. Ein starrer Verbund ermöglicht eine exakte Positionierung der Bauteile, insbesondere eine exakte Positionierung elektrischer Kontakte zwischen den Bauteilen.

In einer Ausführungsform ist die sechste Haltemutter der fünften Haltemutter gegenüberliegend angeordnet. Zwischen der sechsten Haltemutter und der fünften Haltemutter ist die Gehäusewand 1 angeordnet. Die sechste Haltemutter und die fünfte Haltemutter befestigen den zweiten Gewindebolzen 7 an der Gehäusewand 1. Die Befestigung ist derart, dass der zweite Gewindebolzen 7 gegenüber der Gehäusewand 1 im Wesentlichen unbeweglich ist. Vorzugsweise befestigen die sechste Haltemutter und die fünfte Haltemutter den zweiten Gewindebolzen 7 derart an der Gehäusewand 1, dass der zweite Gewindebolzen 7 gegenüber der Gehäusewand 1 unbeweglich ist.

In einer weiteren Ausführungsform ist die sechste Flachmutter der fünften Flachmutter gegenüberliegend angeordnet. Zwischen der sechsten Flachmutter und der fünften Flachmutter ist die Gehäusewand 1 angeordnet. Die sechste Flachmutter und die fünfte Flachmutter befestigen den zweiten Gewindebolzen 7 an der Gehäusewand 1. Die Befestigung ist derart, dass der zweite Gewindebolzen 7 gegenüber der Gehäusewand 1 im Wesentlichen unbeweglich ist. Vorzugsweise befestigen die sechste Flachmutter und die fünfte Flachmutter den zweiten Gewindebolzen 7 derart an der Gehäusewand 1, dass der zweite Gewindebolzen 7 gegenüber der Gehäusewand 1 unbeweglich ist.

In einer speziellen Ausführungsform ist der zweite Gewindebolzen 7 in die Gehäusewand 1 eingedreht. Das heisst, dass die zweite Öffnung in der Gehäusewand 1 ein Innengewinde aufweist, welches zum zweiten Aussengewinde des zweiten Gewindebolzens 7 passt. Insbesondere können das Innengewinde der zweiten Öffnung in der Gehäusewand 1 und das zweite Aussengewinde des zweiten Gewindebolzens 7 beide metrisch sein. In dieser Ausführungsform ist es möglich, dass die fünfte Schraubenmutter oder die sechste Schraubenmutter entfallen. Es können auch die fünfte Schraubenmutter und die sechste Schraubenmutter entfallen. Ebenso ist es möglich, dass die fünfte Haltemutter oder die sechste Haltemutter entfallen. Es können auch die fünfte Haltemutter und die sechste Haltemutter entfallen. Ferner ist es möglich, dass die fünfte Flachmutter oder die sechste Flachmutter entfallen. Es können auch fünfte Flachmutter und die sechste Flachmutter entfallen.

Vorzugsweise verläuft der zweite Gewindebolzen 7 im Wesentlichen senkrecht zur ersten und zur zweiten Seite der Gehäusewand 1. Idealerweise verläuft der zweite Gewindebolzen 7 senkrecht zur ersten und zur zweiten Seite der Gehäusewand 1.

In einer Ausführungsform mit einem zweiten Gewindebolzen 7 weist der Leiterplattenhalter 2 eine zweite Öffnung auf. Die zweite Öffnung in dem Leiterplattenhalter 2 hat vorzugsweise einen kreisförmigen Querschnitt. Die zweite Öffnung in dem Leiterplattenhalter 2 kann weiterhin einen quadratischen, rechteckigen oder sechseckigen Querschnitt aufweisen. Die vorstehende Aufzählung von Querschnitten der zweiten Öffnung in dem Leiterplattenhalter 2 erhebt keinen Anspruch auf Vollständigkeit.

In einer Ausführungsform ist die zweite Öffnung in dem Leiterplattenhalter 2 eine Bohrung. In einer weiteren Ausführungsform ist die zweite Öffnung in dem Leiterplattenhalter 2 gestanzt. Weitere technische Möglichkeiten zum Herstellen der ersten Öffnung in dem Leiterplattenhalter 2 sind einschlägig bekannt. Beispielsweise kann die zweite Öffnung in dem Leiterplattenhalter 2 im Rahmen der Herstellung mit einem additiven Herstellungsverfahren als Aussparung angebracht sein.

Die erste und die zweite Öffnung in dem Leiterplattenhalter 2 können in Form einer einzigen Öffnung in dem Leiterplattenhalter 2 vorliegen. Das heisst, dass die erste und die zweite Öffnung in dem Leiterplattenhalter 2 nicht verschieden voneinander sind.

Durch die zweite Öffnung in dem Leiterplattenhalter 2 ist der zweite Gewindebolzen 7 geführt. Der zweite Gewindebolzen 7 umfasst im Bereich des Leiterplattenhalters 2 vorzugsweise einen zweiten Hohlzylinder mit einem zweiten Aussengewinde, beispielsweise mit einem zweiten metrischen Aussengewinde. Der zweite Gewindebolzen 7 ist im Bereich des Leiterplattenhalters 2 idealerweise ein zweiter Hohlzylinder mit einem zweiten Aussengewinde, beispielsweise mit einem zweiten metrischen Aussengewinde.

Vorzugsweise verläuft der zweite Gewindebolzen 7 im Wesentlichen senkrecht zur ersten und zur zweiten Seite des Leiterplattenhalters 2. Idealerweise verläuft der zweite Gewindebolzen 7 senkrecht zur ersten und zur zweiten Seite des Leiterplattenhalters 2. Zwischen dem Leiterplattenhalter 2 und der Gehäusewand 1 ist ein zweiter Abstandshalter eingefügt. Vorzugsweise ist zwischen dem Leiterplattenhalter 2 und der zweiten Seite der Gehäusewand 1 ein zweiter Abstandshalter eingefügt. Idealerweise verläuft ein Abschnitt des zweiten Gewindebolzens 7 innerhalb des zweiten Abstandshalters.

Der zweite Abstandshalter ist aus einem Material hergestellt, welches kompatibel ist mit dem Material des zweiten Gewindebolzens 7. Der zweite Abstandshalter ist ebenso aus einem Material hergestellt, welches kompatibel ist mit dem Material des Leiterplattenhalters 2. Ferner ist der zweite Abstandshalter ebenso aus einem Material hergestellt, welches kompatibel ist mit dem Material der sechsten Schraubenmutter, insbesondere der sechsten Haltemutter und/oder der sechsten Flachmutter.

Der zweite Abstandshalter kann beispielsweise aus einem Metall wie Aluminium und/oder Stahl und/oder ferritischer Stahl und/oder austenitischer Stahl und/oder Messing hergestellt sein. Der zweite Abstandshalter kann ebenso aus einem Kunststoff hergestellt sein. Die vorstehenden Listen an Materialien des zweiten Abstandshalters sind nicht abschliessend.

Der zweite Abstandshalter hat eine Längendimension, welche parallel zum zweiten Gewindebolzen 7 ist. Insbesondere ist die Längendimension des zweiten Abstandshalters parallel zu einer Achse des zweiten Gewindebolzens 7, wobei der zweite Gewindebolzen 7 um jene Achse im Wesentlichen zylindersymmetrisch ist. In einer Ausführungsform ist der zweite Gewindebolzen 7 bis auf sein zweites Aussengewinde zylindersymmetrisch zu jener Achse des zweiten Gewindebolzens 7.

Die Längendimension des zweiten Abstandshalters kann beispielsweise mehr als einen Millimeter oder mehr als zwei Millimeter oder mehr als fünf Millimeter betragen. Ein ausreichender Abstand des Leiterplattenhalters 2 von der Gehäusewand 1 trägt zur elektrischen und/oder thermischen Isolierung beider Bauteile bei. Ein ausreichender Abstand des Leiterplattenhalters 2 von der zweiten Seite der Gehäusewand 1 trägt zur elektrischen und/oder thermischen Isolierung beider Bauteile bei.

Der zweite Abstandshalter weist eine erste Seite auf. Die erste Seite des zweiten Abstandshalters grenzt vorzugsweise an die sechste Schraubenmutter. Die erste Seite des zweiten Abstandshalters grenzt vorzugsweise an die sechste Haltemutter. In einer weiteren Ausführungsform grenzt die erste Seite des zweiten Abstandshalters an die sechste Flachmutter.

Der zweite Abstandshalter weist eine zweite Seite auf. Die zweite Seite des zweiten Abstandshalters ist verschieden von der ersten Seite des zweiten Abstandshalters. Vorzugsweise sind die erste und die zweite Seite des zweiten Abstandshalters parallel zueinander.

Die Längendimension des zweiten Abstandshalters entspricht einem kürzesten Abstand zwischen der ersten und der zweiten Seite des zweiten Abstandshalters. Die Längendimension ist idealerweise ein kürzester Abstand zwischen der ersten und der zweiten Seite des zweiten Abstandshalters.

Vorzugsweise ist die Längendimension des zweiten Abstandshalters im Wesentlichen gleich der Längendimension des ersten Abstandshalters. Idealerweise ist die Längendimension des zweiten Abstandshalters gleich der Längendimension des ersten Abstandshalters. Gleiche Längendimensionen der ersten und zweiten Abstandshalter ermöglichen einen hohen Anteil gleicher Teile. Mithin vermindert sich die Komplexität der Lösung.

Die zweite Seite des zweiten Abstandshalters grenzt an den Leiterplattenhalter 2. Insbesondere grenzt die zweite Seite des zweiten Abstandshalters an die erste Seite des Leiterplattenhalters 2. In einer Ausführungsform liegt die zweite Seite des zweiten Abstandshalters auf der ersten Seite des Leiterplattenhalters 2 auf.

An der zweiten Seite der Leiterplattenhalters 2 ist eine siebte Schraubenmutter so an den zweiten Gewindebolzen 7 angebracht, dass die siebte Schraubenmutter an die zweite Seite des Leiterplattenhalters 2 grenzt. Die siebte Schraubenmutter umfasst vorzugsweise eine siebte Haltemutter und/oder eine siebte Flachmutter. Die siebte Schraubenmutter ist idealerweise eine siebte Haltemutter und/oder eine siebte Flachmutter. Die siebte Schraubenmutter ist beispielsweise eine siebte Schraubenmutter mit einem metrischen Gewinde an einer Innenseite der siebten Schraubenmutter.

Die siebte Schraubenmutter ist aus einem Material hergestellt, welches kompatibel ist mit dem Material des zweiten Gewindebolzens 7. Die siebte Schraubenmutter ist ebenso aus einem Material hergestellt, welches kompatibel ist mit dem Material des Leiterplattenhalters 2. Die siebte Schraubenmutter kann beispielsweise aus einem Metall wie Aluminium und/oder Stahl und/oder ferritischer Stahl und/oder austenitischer Stahl und/oder Messing hergestellt sein. Die siebte Schraubenmutter kann ebenso aus einem Kunststoff hergestellt sein. Die vorstehenden Listen an Materialien der siebten Schraubenmutter sind nicht abschliessend.

Die siebte Schraubenmutter ist dem zweiten Abstandshalter gegenüberliegend angeordnet. Zwischen der siebten Schraubenmutter und dem zweiten Abstandshalter ist der Leiterplattenhalter 2 angeordnet. Die siebte Schraubenmutter und der zweite Abstandshalter befestigen den zweiten Gewindebolzen 7 an dem Leiterplattenhalter 2. Die Befestigung ist derart, dass der zweite Gewindebolzen 7 gegenüber dem Leiterplattenhalter 2 im Wesentlichen unbeweglich ist. Vorzugsweise befestigen die siebte Schraubenmutter und der zweite Abstandshalter den zweiten Gewindebolzen 7 derart an dem Leiterplattenhalter 2, dass der zweite Gewindebolzen 7 gegenüber dem Leiterplattenhalter 2 unbeweglich ist.

In einer Ausführungsform ist die siebte Haltemutter und/oder siebte Flachmutter dem zweiten Abstandshalter gegenüberliegend angeordnet. Zwischen der siebten Haltemutter und/oder der siebten Flachmutter und dem zweiten Abstandshalter ist der Leiterplattenhalter 2 angeordnet. Die siebte Haltemutter und/oder siebte Flachmutter und der zweite Abstandshalter befestigen den zweiten Gewindebolzen 7 an dem Leiterplattenhalter 2. Die Befestigung ist derart, dass der zweite Gewindebolzen 7 gegenüber dem Leiterplattenhalter 2 im Wesentlichen unbeweglich ist. Vorzugsweise ist die Befestigung derart, dass der zweite Gewindebolzen 7 gegenüber dem Leiterplattenhalter 2 unbeweglich ist.

In einer speziellen Ausführungsform ist der zweite Gewindebolzen 7 in den Leiterplattenhalter 2 eingedreht. Das heisst, dass die zweite Öffnung in dem Leiterplattenhalter 2 ein Innengewinde aufweist, welches zum zweiten Aussengewinde des zweiten Gewindebolzens 7 passt. Insbesondere können das Innengewinde der zweiten Öffnung in dem Leiterplattenhalter 2 und das zweite Aussengewinde des zweiten Gewindebolzens 7 beide metrisch sein. In dieser Ausführungsform ist es möglich, dass die siebte Schraubenmutter oder der zweite Abstandshalter entfallen. Es können auch die siebte Schraubenmutter und der zweite Abstandshalter entfallen. Ebenso ist es möglich, dass die siebte Haltemutter oder der zweite Abstandshalter entfallen. Es können auch die siebte Haltemutter und der zweite Abstandshalter entfallen. Ferner ist es möglich, dass die siebte Flachmutter oder der zweite Abstandshalter entfallen. Es können auch die siebte Flachmutter und der zweite Abstandshalter entfallen.

Ausserdem kann anstelle des zweiten Abstandshalters eine achte Schraubenmutter so angebracht sein, dass sie an die erste Seite des Leiterplattenhalters 2 grenzt. Der Leiterplattenhalter 2 liegt zwischen der siebten Schraubenmutter auf der zweiten Seite des Leiterplattenhalters 2 und der achten Schraubenmutter auf der ersten Seite des Leiterplattenhalters 2. Die siebte Schraubenmutter und die achte Schraubenmutter befestigen den zweiten Gewindebolzen 7 an dem Leiterplattenhalter 2. Die Befestigung ist derart, dass der zweite Gewindebolzen 7 gegenüber dem Leiterplattenhalter 2 im Wesentlichen unbeweglich ist. Vorzugsweise befestigen die siebte Schraubenmutter und die achte Schraubenmutter den zweiten Gewindebolzen 7 derart an dem Leiterplattenhalter 2, dass der zweite Gewindebolzen 7 gegenüber dem Leiterplattenhalter 2 unbeweglich ist. Ein starrer Verbund ermöglicht eine exakte Positionierung der Bauteile, insbesondere eine exakte Positionierung elektrischer Kontakte zwischen den Bauteilen.

Die achte Schraubenmutter kann eine achte Haltemutter umfassen. Insbesondere kann die achte Schraubenmutter eine achte Haltemutter sein. In einer Ausführungsform ist die siebte Haltemutter der achten Haltemutter gegenüberliegend angeordnet. Zwischen der siebten Haltemutter und der achten Haltemutter ist der Leiterplattenhalter 2 angeordnet. Die siebte Haltemutter und die achte Haltemutter befestigen den zweiten Gewindebolzen 7 an dem Leiterplattenhalter 2. Die Befestigung ist derart, dass der zweite Gewindebolzen 7 gegenüber dem Leiterplattenhalter 2 im Wesentlichen unbeweglich ist. Vorzugsweise ist die Befestigung derart, dass der zweite Gewindebolzen 7 gegenüber dem Leiterplattenhalter 2 unbeweglich ist.

Die achte Schraubenmutter kann eine achte Flachmutter umfassen. Insbesondere kann die achte Schraubenmutter eine achte Flachmutter sein. In einer Ausführungsform ist die siebte Flachmutter der achten Flachmutter gegenüberliegend angeordnet. Zwischen der siebten Flachmutter und der achten Flachmutter ist der Leiterplattenhalter 2 angeordnet. Die siebte Flachmutter und die achte Flachmutter befestigen den zweiten Gewindebolzen 7 an dem Leiterplattenhalter 2. Die Befestigung ist derart, dass der zweite Gewindebolzen 7 gegenüber dem Leiterplattenhalter 2 im Wesentlichen unbeweglich ist. Vorzugsweise ist die Befestigung derart, dass der zweite Gewindebolzen 7 gegenüber dem Leiterplattenhalter 2 unbeweglich ist.

FIG 2 zeigt ein Ende des ersten Gewindebolzens 6. Das Ende des ersten Gewindebolzens 6 ist in Richtung der Leiterplatte 4 gerichtet. Am Ende des ersten Gewindebolzens 6 ragt mindestens ein erster Leiter aus dem ersten Hohlzylinder des ersten Gewindebolzens 6. Vorzugsweise ragt am Ende des ersten Gewindebolzens 6 eine erste Vielzahl von Leitern aus dem ersten Hohlzylinder des ersten Gewindebolzens 6. Die erste Vielzahl von Leitern, welche aus dem ersten Hohlzylinder des ersten Gewindebolzens 6 ragt, kann beispielsweise zwei oder fünf oder zehn Leiter umfassen.

In einer Ausführungsform ragt mindestens ein erster elektrischer Leiter, beispielsweise ein erster elektrischer Kupferleiter, aus dem ersten Hohlzylinder des ersten Gewindebolzens 6. In einer anderen Ausführungsform ragt eine erste Vielzahl elektrischer Leiter, beispielsweise eine erste Vielzahl elektrischer Kupferleiter, aus dem ersten Hohlzylinder des ersten Gewindebolzens 6. Ferner kann mindestens ein erster optischer Leiter, beispielsweise ein erster Lichtwellenleiter, aus dem ersten Hohlzylinder des ersten Gewindebolzens 6 ragen. Insbesondere können mindestens ein erster elektrischer Leiter und mindestens ein erster optischer Leiter aus dem ersten Hohlzylinder des ersten Gewindebolzens 6 ragen.

Am Ende des ersten Gewindebolzens 6 kann ein erster Stopfen angebracht sein. Der erste Stopfen ist vorteilhaft innen im ersten Hohlzylinder des ersten Gewindebolzens 6 angebracht. Der erste Stopfen befestigt den mindestens einen ersten Leiter oder die erste Vielzahl an Leitern. Insbesondere kann der erste Stopfen den mindestens einen ersten elektrischen Leiter oder die erste Vielzahl elektrischer Leiter befestigen. Ferner kann der erste Stopfen den mindestens einen ersten elektrischen Leiter und den mindestens einen ersten optischen Leiter befestigen.

Die Befestigung durch den ersten Stopfen ist zunächst gegenüber dem ersten Gewindebolzen 6. Die Befestigung ist ferner gegenüber der Leiterplatte 4. Das heisst, dass der mindestens eine erste Leiter durch den ersten Stopfen so ausgerichtet ist, dass er direkt an der Leiterplatte 4 angebracht werden kann. Beispielsweise kann der mindestens eine erste Leiter direkt auf der Leiterplatte 4 aufgelötet werden. Insbesondere ist möglich, dass der mindestens eine erste elektrische Leiter direkt auf der Leiterplatte 4 aufgelötet werden kann. Ferner kann die erste Vielzahl an Leitern so ausgerichtet sein, dass die Leiter der ersten Vielzahl an Leitern direkt an der Leiterplatte 4 angebracht werden können. Beispielsweise können die Leiter der ersten Vielzahl an Leitern direkt auf der Leiterplatte 4 aufgelötet werden. Insbesondere ist möglich, dass die elektrischen Leiter der ersten Vielzahl an Leitern direkt auf der Leiterplatte 4 aufgelötet werden können.

Ferner kann am Ende des ersten Gewindebolzens 6 ein erster männlicher oder weiblicher Schraubstecker angebracht sein. Zum ersten männlichen oder weiblichen Schraubstecker des ersten Gewindebolzens 6 gibt es dann an der Leiterplatte 4 ein erstes passendes Gegenstück. Der erste männliche oder weibliche Schraubstecker ermöglicht die Befestigung des mindestens einen ersten Leiters oder der ersten Vielzahl an Leitern an der Leiterplatte 4. Dazu wird der erste männliche oder weibliche Schraubstecker mit seinem ersten passenden Gegenstück verschraubt. Insbesondere kann der mindestens eine erste elektrische Leiter oder die erste Vielzahl elektrischer Leiter anhand des ersten Schraubsteckers und des ersten Gegenstückes befestigt werden. Auch kann der mindestens eine erste Kupferleiter oder die erste Vielzahl an Kupferleitern anhand des ersten Schraubsteckers und des ersten Gegenstückes befestigt werden. Mithin werden der erste elektrische Leiter oder die ersten elektrischen Leiter anhand des ersten Schraubsteckers und des ersten Gegenstückes direkt mit der Leiterplatte 4 verbunden.

Durch die Ausrichtung und direkte Verbindung entfallen idealerweise alle Kabel-an-Leiterplatte Verbindungen zwischen dem ersten Stopfen und der Leiterplatte 4. Die Anordnung wird dadurch robuster gegen mechanische Einwirkung und weniger komplex.

In einer speziellen Ausführungsform ist mindestens ein erster optischer Leiter durch den ersten Stopfen so ausgerichtet, dass er direkt mit der Leiterplatte 4 verbunden werden kann. Weiterhin kann eine erste Vielzahl optischer Leiter durch den ersten Stopfen ausgerichtet sein. Die Ausrichtung ist derart, dass die optischen Leiter der ersten Vielzahl optischer Leiter direkt mit der Leiterplatte 4 verbunden werden können.

Ferner kann der mindestens eine erste optische Leiter anhand des ersten männlichen oder weiblichen Schraubsteckers direkt mit der Leiterplatte 4 verbunden werden. Weiterhin kann eine erste Vielzahl optischer Leiter anhand des ersten männlichen oder weiblichen Schraubsteckers direkt mit der Leiterplatte 4 verbunden werden.

Gemäss einer Variante der vorliegenden Offenbarung kann der erste männliche oder weibliche Schraubstecker einen ersten Temperatursensor enthalten. Der erste Temperatursensor kann beispielsweise ein erster temperaturabhängiger elektrischer Widerstand sein. Die Leiterplatte 4 kontaktiert den ersten Temperatursensor elektrisch, indem der erste männliche oder weibliche Schraubstecker mit seinem ersten passenden Gegenstück verschraubt wird. Der erste Temperatursensor ermöglicht so eine Temperaturmessung im oder am ersten männlichen oder weiblichen Schraubstecker. So kann ein überhitzender Schraubstecker oder eine überhitzende elektrische Verbindung detektiert werden.

Es kann auch ein zweiter Gewindebolzen 7 vorhanden sein. FIG 2 zeigt ein Ende des zweiten Gewindebolzens 7. Das Ende des zweiten Gewindebolzens 7 ist in Richtung der Leiterplatte 4 gerichtet. Am Ende des zweiten Gewindebolzens 7 ragt mindestens ein zweiter Leiter aus dem zweiten Hohlzylinder des zweiten Gewindebolzens 7. Vorzugsweise ragt am Ende des zweiten Gewindebolzens 7 eine zweite Vielzahl von Leitern aus dem zweiten Hohlzylinder des zweiten Gewindebolzens 7. Die zweite Vielzahl von Leitern, welche aus dem zweiten Hohlzylinder des zweiten Gewindebolzens 7 ragt, kann beispielsweise zwei oder fünf oder zehn Leiter umfassen.

In einer Ausführungsform ragt mindestens ein zweiter elektrischer Leiter, beispielsweise ein zweiter elektrischer Kupferleiter, aus dem zweiten Hohlzylinder des zweiten Gewindebolzens 7. In einer anderen Ausführungsform ragt eine zweite Vielzahl elektrischer Leiter, beispielsweise eine zweite Vielzahl elektrischer Kupferleiter, aus dem zweiten Hohlzylinder des zweiten Gewindebolzens 7. Ferner kann mindestens ein zweiter optischer Leiter, beispielsweise ein zweiter Lichtwellenleiter, aus dem zweiten Hohlzylinder des zweiten Gewindebolzens 7 ragen. Insbesondere können mindestens ein zweiter elektrischer Leiter und mindestens ein zweiter optischer Leiter aus dem zweiten Hohlzylinder des zweiten Gewindebolzens 7 ragen.

Am Ende des zweiten Gewindebolzens 7 kann ein zweiter Stopfen angebracht sein. Der zweite Stopfen ist vorteilhaft innen im zweiten Hohlzylinder des zweiten Gewindebolzens 7 angebracht. Der zweite Stopfen befestigt den mindestens einen zweiten Leiter oder die zweite Vielzahl an Leitern. Insbesondere kann der zweite Stopfen den mindestens einen zweiten elektrischen Leiter oder die zweite Vielzahl elektrischer Leiter befestigen. Ferner kann der zweite Stopfen den mindestens einen zweiten elektrischen Leiter und den mindestens einen zweiten optischen Leiter befestigen.

Die Befestigung durch den zweiten Stopfen ist zunächst gegenüber dem zweiten Gewindebolzen 7. Die Befestigung ist ferner gegenüber der Leiterplatte 4. Das heisst, dass der mindestens eine zweite Leiter durch den zweiten Stopfen so ausgerichtet ist, dass er direkt an der Leiterplatte 4 angebracht werden kann. Beispielsweise kann der mindestens eine zweite Leiter direkt auf der Leiterplatte 4 aufgelötet werden. Insbesondere ist möglich, dass der mindestens eine zweite elektrische Leiter direkt auf der Leiterplatte 4 aufgelötet werden kann. Ferner kann die zweite Vielzahl an Leitern so ausgerichtet sein, dass die Leiter der zweiten Vielzahl an Leitern direkt an der Leiterplatte 4 angebracht werden können. Beispielsweise können die Leiter der zweiten Vielzahl an Leitern direkt auf der Leiterplatte 4 aufgelötet werden. Insbesondere ist möglich, dass die elektrischen Leiter der zweiten Vielzahl an Leitern direkt auf der Leiterplatte 4 aufgelötet werden können.

Ferner kann am Ende des zweiten Gewindebolzens 7 ein zweiter männlicher oder weiblicher Schraubstecker angebracht sein. Zum zweiten männlichen oder weiblichen Schraubstecker des zweiten Gewindebolzens 7 gibt es dann an der Leiterplatte 4 ein zweites passendes Gegenstück. Der zweite männliche oder weibliche Schraubstecker ermöglicht die Befestigung des mindestens einen zweiten Leiters oder der zweiten Vielzahl an Leitern an der Leiterplatte 4. Dazu wird der zweite männliche oder weibliche Schraubstecker mit seinem zweiten passenden Gegenstück verschraubt. Insbesondere kann der mindestens eine zweite elektrische Leiter oder die zweite Vielzahl elektrischer Leiter anhand des zweiten Schraubsteckers und des zweiten Gegenstückes befestigt werden. Auch kann der mindestens eine zweite Kupferleiter oder die zweite Vielzahl an Kupferleitern anhand des zweiten Schraubsteckers und des zweiten Gegenstückes befestigt werden. Mithin werden der zweite elektrische Leiter oder die zweiten elektrischen Leiter anhand des zweiten Schraubsteckers und des zweiten Gegenstückes direkt mit der Leiterplatte 4 verbunden.

Durch die Ausrichtung und direkte Verbindung entfallen idealerweise alle Kabel-an-Leiterplatte Verbindungen zwischen dem zweiten Stopfen und der Leiterplatte 4. Die Anordnung wird dadurch robuster gegen mechanische Einwirkung und weniger komplex.

In einer speziellen Ausführungsform ist mindestens ein zweiter optischer Leiter durch den zweiten Stopfen so ausgerichtet, dass er direkt mit der Leiterplatte 4 verbunden werden kann. Weiterhin kann eine zweite Vielzahl optischer Leiter durch den zweiten Stopfen ausgerichtet sein. Die Ausrichtung ist derart, dass die optischen Leiter der zweiten Vielzahl optischer Leiter direkt mit der Leiterplatte 4 verbunden werden können.

Ferner kann der mindestens eine zweite optische Leiter anhand des zweiten männlichen oder weiblichen Schraubsteckers direkt mit der Leiterplatte 4 verbunden werden. Weiterhin kann eine zweite Vielzahl optischer Leiter anhand des zweiten männlichen oder weiblichen Schraubsteckers direkt mit der Leiterplatte 4 verbunden werden.

Der zweite Schraubstecker ist gemäss einem Aspekt der vorliegenden Offenbarung dahingehend verschieden vom ersten Schraubstecker, dass der zweite Schraubstecker einen Toleranzausgleich ermöglicht. Insbesondere kann der zweite Schraubstecker zum Zweck des Toleranzausgleiches ein elastisches Teil umfassen.

Längen, Dicken, Durchmesser und Flächen dieser Offenbarung beziehen sich auf dreihundert Kelvin und auf eintausenddreizehn Hektopascal, sofern nicht anders angegeben.

Mit anderen Worten, die vorliegende Offenbarung lehrt eine Anordnung zur Befestigung einer Leiterplatte (4), die Anordnung umfassend:
ein erstes röhrenförmiges Befestigungselement (6) und mindestens einen ersten Leiter innen im ersten röhrenförmigen Befestigungselement (6);
die Anordnung zusätzlich umfassend eine Halterung (2) für die Leiterplatte (4);
wobei die Halterung (2) mindestens einen Vorsprung zur mechanischen Befestigung der Leiterplatte (4) umfasst;
wobei die Halterung (2) eine erste Öffnung umfasst;
wobei das erste röhrenförmige Befestigungselement (6) durch die erste Öffnung in der Halterung (2) geführt ist;
wobei das erste röhrenförmige Befestigungselement (6) mechanisch derart fest mit der Halterung (2) verbunden ist, dass die Halterung (2) gegenüber dem ersten röhrenförmigen Befestigungselement (6) im Wesentlichen unbeweglich ist;
die Anordnung zusätzlich umfassend einen ersten Anschluss zur starren Verbindung des mindestens einen ersten Leiters mit der Leiterplatte (4);
wobei das erste röhrenförmige Befestigungselement (6) ein Ende umfasst, welches von der Halterung (2) weggerichtet ist; und
wobei der erste Anschluss am Ende des ersten röhrenförmigen Befestigungselementes (6) angeordnet ist.

Gemäss einer Ausführungsform weist das erste röhrenförmige Befestigungselement (6) einen Innenraum auf. Der mindestens eine erste Leiter verläuft im Innenraum des ersten röhrenförmigen Befestigungselementes (6). Der Innenraum des ersten röhrenförmigen Befestigungselementes (6) kann hohl sein. Das heisst, dass der Innenraum des ersten röhrenförmigen Befestigungselementes (6) ein Hohlraum ist.

Vorzugsweise ist das das erste röhrenförmige Befestigungselement (6) mechanisch formschlüssig mit der Halterung (2) verbunden, so dass die Halterung (2) gegenüber dem ersten röhrenförmigen Befestigungselement (6) im Wesentlichen unbeweglich ist.

In einer Ausführungsform umfasst die Leiterplatte (4) eine elektrische Leiterplatte (4). Bevorzugt ist die Leiterplatte (4) eine elektrische Leiterplatte (4). In einer weiteren Ausführungsform umfasst die Leiterplatte (4) eine gedruckte elektrische Leiterplatte (4). Bevorzugt ist die Leiterplatte (4) eine gedruckte elektrische Leiterplatte (4). In einer verwandten Ausführungsform umfasst die Leiterplatte (4) eine bedruckbare elektrische Leiterplatte (4). Bevorzugt ist die Leiterplatte (4) eine bedruckbare elektrische Leiterplatte (4).

Gemäss einer Ausführungsform umfasst das erste röhrenförmige Befestigungselement (6) ein erstes und im Wesentlichen zylindrisches Befestigungselement (6). Gemäss einer speziellen Ausführungsform umfasst das erste röhrenförmige Befestigungselement (6) ein erstes und zylindrisches Befestigungselement (6).

Der erste Anschluss ist vorzugsweise ein erster Anschluss zur fixen Verbindung des mindestens einen ersten Leiters mit der Leiterplatte (4). Der erste Anschluss kann ferner ein erster Anschluss zur festen Verbindung des mindestens einen ersten Leiters mit der Leiterplatte (4) sein.

In einer Ausführungsform umfasst der erste Anschluss eine erste starre Verbindung des mindestens einen ersten Leiters mit der Leiterplatte (4). In einer verwandten Ausführungsform umfasst der erste Anschluss eine erste fixe Verbindung des mindestens einen ersten Leiters mit der Leiterplatte (4). In wiederum einer verwandten Ausführungsform umfasst der erste Anschluss eine erste feste Verbindung des mindestens einen ersten Leiters mit der Leiterplatte (4).

Der mindestens eine Vorsprung umfasst ein erstes Ende und ein zweites Ende. Das zweite Ende des mindestens einen Vorsprunges ist verschieden vom ersten Ende des mindestens einen Vorsprunges. Das erste Ende des mindestens einen Vorsprunges verbindet den mindestens einen Vorsprung mit der Halterung (2). Das zweite Ende des mindestens einen Vorsprunges ist zur mechanischen Befestigung der Leiterplatte (4) an dem mindestens einen Vorsprung und an der Halterung (2).

Das erste röhrenförmige Befestigungselement (6) umfasst ein Ende, welches zur Leiterplatte (4) gerichtet ist. Vorzugsweise sind der mindestens eine Vorsprung und das erste röhrenförmige Befestigungselement (6) jeweils von der Halterung (2) weggerichtet. Idealerweise umfasst der mindestens eine Vorsprung ein erstes Ende und ein zweites Ende, wobei das zweite Ende des mindestens einen Vorsprunges verschieden ist vom ersten Ende des mindestens einen Vorsprunges, wobei das erste Ende des mindestens einen Vorsprunges den mindestens einen Vorsprung mit der Halterung (2) verbindet, wobei das zweite Ende des mindestens einen Vorsprunges zur mechanischen Befestigung der Leiterplatte (4) an dem mindestens einen Vorsprung und an der Halterung (2) ist, wobei das zweite Ende des mindestens einen Vorsprunges eine erste Richtung definiert, wobei das zweite Ende des mindestens einen Vorsprunges und das Ende des ersten röhrenförmigen Befestigungselementes (6) in der ersten Richtung von der Halterung (2) weggerichtet sind. Idealerweise ist das erste röhrenförmige Befestigungselement (6) mechanisch derart fest mit der Halterung (2) verbunden, dass die Halterung (2) gegenüber dem ersten röhrenförmigen Befestigungselement (6) unbeweglich ist.

In einer Ausführungsform ist das erste röhrenförmige Befestigungselement (6) derart fest mit der Halterung (2) verschraubt, dass die Halterung (2) gegenüber dem ersten röhrenförmigen Befestigungselement (6) im Wesentlichen unbeweglich ist. In einer verwandten Ausführungsform ist das erste röhrenförmige Befestigungselement (6) derart fest mit der Halterung (2) verschraubt, dass die Halterung (2) gegenüber dem ersten röhrenförmigen Befestigungselement (6) unbeweglich ist. In einer weiteren Ausführungsform ist das erste röhrenförmige Befestigungselement (6) derart fest mit der Halterung (2) verklebt, dass die Halterung (2) gegenüber dem ersten röhrenförmigen Befestigungselement (6) im Wesentlichen unbeweglich ist. In einer verwandten Ausführungsform ist das erste röhrenförmige Befestigungselement (6) derart fest mit der Halterung (2) verklebt, dass die Halterung (2) gegenüber dem ersten röhrenförmigen Befestigungselement (6) unbeweglich ist. In wiederum einer weiteren Ausführungsform ist das erste röhrenförmige Befestigungselement (6) derart fest mit der Halterung (2) anhand einer Schrumpfpassung verbunden, dass die Halterung (2) gegenüber dem ersten röhrenförmigen Befestigungselement (6) im Wesentlichen unbeweglich ist. In einer verwandten Ausführungsform ist das erste röhrenförmige Befestigungselement (6) derart fest mit der Halterung (2) anhand einer Schrumpfpassung verbunden, dass die Halterung (2) gegenüber dem ersten röhrenförmigen Befestigungselement (6) unbeweglich ist.

Die vorliegende Offenbarung lehrt weiterhin eine der vorgenannten Anordnungen, die Anordnung zusätzlich umfassend die Leiterplatte (4);
wobei die Leiterplatte (4) anhand des mindestens einen Vorsprunges mechanisch an der Halterung (2) befestigt ist; und
wobei der mindestens eine erste Leiter mit der Leiterplatte (4) anhand des ersten Anschlusses starr verbunden ist.

Die vorliegende Offenbarung lehrt ferner eine der vorgenannten Anordnungen, wobei der erste Anschluss einen ersten elektrischen Anschluss umfasst und wobei der mindestens eine erste Leiter mindestens einen ersten elektrischen Leiter umfasst.

Vorzugsweise ist der erste Anschluss ein erster elektrischer Anschluss. Vorzugsweise ist der mindestens eine erste Leiter mindestens ein erster elektrischer Leiter.

Die vorliegende Offenbarung lehrt ausserdem eine der vorgenannten Anordnungen, wobei der erste Anschluss einen ersten Anschluss für einen Lichtwellenleiter umfasst und wobei der mindestens eine erste Leiter mindestens einen ersten Lichtwellenleiter umfasst.

Vorzugsweise ist der erste Anschluss ein erster Anschluss für einen Lichtwellenleiter. Vorzugsweise ist der mindestens eine erste Leiter mindestens ein erster Lichtwellenleiter.

Lichtwellenleiter verschaffen Vorteile beispielsweise in Umgebungen mit Explosionsgefahr. In solchen Umgebungen sollten elektrische Verbindungen auf ein Minimum reduziert werden.

Die vorliegende Offenbarung lehrt darüber hinaus eine der vorgenannten Anordnungen, wobei das erste röhrenförmige Befestigungselement (6) senkrecht zur Halterung (2) angeordnet ist.

Vorzugsweise hat das erste röhrenförmige Befestigungselement (6) eine erste Symmetrieachse;
wobei das erste röhrenförmige Befestigungselement (6) im Wesentlichen zylindersymmetrisch zu der ersten Symmetrieachse des ersten röhrenförmigen Befestigungselementes (6) ist; und
wobei die erste Symmetrieachse des ersten röhrenförmigen Befestigungselementes (6) senkrecht zur Halterung (2) verläuft.

Idealerweise hat das erste röhrenförmige Befestigungselement (6) eine erste Symmetrieachse;
wobei das erste röhrenförmige Befestigungselement (6) zylindersymmetrisch zu der ersten Symmetrieachse des ersten röhrenförmigen Befestigungselementes (6) ist; und
wobei die erste Symmetrieachse des ersten röhrenförmigen Befestigungselementes (6) senkrecht zur Halterung (2) verläuft.

Die vorliegende Offenbarung lehrt zudem eine der vorgenannten Anordnungen,
wobei die Halterung (2) und der mindestens eine Vorsprung zur mechanischen Befestigung der Leiterplatte (4) aus einem Stück gefertigt sind.

Es ist vorgesehen, dass die Halterung (2) und der mindestens eine Vorsprung zur mechanischen Befestigung der Leiterplatte (4) einstückig sind. Die Halterung (2) und der mindestens eine Vorsprung zur mechanischen Befestigung der Leiterplatte (4) können beispielsweise anhand eines Spritzgussverfahrens oder anhand eines additiven Verfahrens aus einem Stück gefertigt sein. Mithin wird die Komplexität der Anordnung reduziert. Weiterhin reduziert sich die Wahrscheinlichkeit eines Ausfalles, weil weniger Teile zu verbinden sind und weniger Verbindungsstellen infolge mechanischer Belastung brechen können.

Die vorliegende Offenbarung lehrt weiterhin eine der vorgenannten Anordnungen,
wobei die Anordnung zusätzlich eine Gehäusewand (1) umfasst;
wobei die Gehäusewand (1) eine erste Öffnung umfasst;
wobei das erste röhrenförmige Befestigungselement (6) durch die erste Öffnung in der Gehäusewand (1) geführt ist; und
wobei das erste röhrenförmige Befestigungselement (6) mechanisch derart fest mit der Gehäusewand (1) verbunden ist, dass die Gehäusewand (1) gegenüber dem ersten röhrenförmigen Befestigungselement (6) im Wesentlichen unbeweglich ist.

Idealerweise ist das erste röhrenförmige Befestigungselement (6) mechanisch derart fest mit der Gehäusewand (1) verbunden, dass die Gehäusewand (1) gegenüber dem ersten röhrenförmigen Befestigungselement (6) unbeweglich ist.

Vorzugsweise ist das erste röhrenförmige Befestigungselement (6) mechanisch formschlüssig mit der Gehäusewand (1) verbunden, so dass die Gehäusewand (1) gegenüber dem ersten röhrenförmigen Befestigungselement (6) im Wesentlichen unbeweglich ist.

Die vorliegende Offenbarung lehrt weiterhin eine der vorgenannten Anordnungen mit einer Gehäusewand (1),
wobei die Halterung (2) eine erste und eine zweite Seite umfasst;
wobei die zweite Seite der Halterung (2) verschieden ist von der ersten Seite der Halterung (2);
wobei die zweite Seite der Halterung (2) der ersten Seite der Halterung (2) gegenüberliegt;
wobei die erste Seite der Halterung (2) in Richtung der Gehäusewand (1) gerichtet ist; und
wobei der mindestens eine Vorsprung zur mechanischen Befestigung der Leiterplatte (4) von der zweiten Seite der Halterung (2) hervorragt.

Vorteilhaft bilden die zweite Seite der Halterung (2) und die erste Seite der Halterung (2) einander gegenüberliegende Seiten der Halterung (2).

Die vorliegende Offenbarung lehrt ferner eine der vorgenannten Anordnungen mit einer Gehäusewand (1), wobei die Halterung (2) zwischen der Gehäusewand (1) und dem ersten Anschluss angeordnet ist.

Idealerweise ist die Halterung (2) zwischen der Gehäusewand (1) und der Leiterplatte (4) angeordnet.

Die vorliegende Offenbarung lehrt ausserdem eine der vorgenannten Anordnungen mit einer Gehäusewand (1), wobei das erste röhrenförmige Befestigungselement (6) senkrecht zur Gehäusewand (1) angeordnet ist.

Vorzugsweise hat das erste röhrenförmige Befestigungselement (6) eine erste Symmetrieachse;
wobei das erste röhrenförmige Befestigungselement (6) im Wesentlichen zylindersymmetrisch zu der ersten Symmetrieachse des ersten röhrenförmigen Befestigungselementes (6) ist; und
wobei die erste Symmetrieachse des ersten röhrenförmigen Befestigungselementes (6) senkrecht zur Gehäusewand (1) verläuft.

Idealerweise hat das erste röhrenförmige Befestigungselement (6) eine erste Symmetrieachse;
wobei das erste röhrenförmige Befestigungselement (6) zylindersymmetrisch zu der ersten Symmetrieachse des ersten röhrenförmigen Befestigungselementes (6) ist; und
wobei die erste Symmetrieachse des ersten röhrenförmigen Befestigungselementes (6) senkrecht zur Gehäusewand (1) verläuft.

Die vorliegende Offenbarung lehrt darüber hinaus eine der vorgenannten Anordnungen mit einer Gehäusewand (1), wobei das erste röhrenförmige Befestigungselement (6) die einzige mechanische Verbindung zwischen der Halterung (2) und der Gehäusewand (1) ist.

Die vorliegende Offenbarung lehrt ferner eine der vorangegangenen Anordnungen umfassend eine Gehäusewand (1), wobei das erste röhrenförmige Befestigungselement (6) die einzige röhrenförmige mechanische Verbindung zwischen der Halterung (2) und der Gehäusewand (1) ist.

Die vorliegende Offenbarung lehrt weiterhin eine der vorangegangenen Anordnungen umfassend eine Gehäusewand (1), wobei das erste röhrenförmige Befestigungselement (6) im Wesentlichen die einzige mechanische Verbindung zwischen der Halterung (2) und der Gehäusewand (1) ist.

Die vorliegende Offenbarung lehrt zudem eine der vorgenannten Anordnungen mit einer Gehäusewand (1),
wobei der erste Anschluss einen ersten männlichen oder weiblichen Schraubstecker umfasst, sodass der erste männliche oder weibliche Schraubstecker die starre Verbindung des mindestens einen ersten Leiters mit der Leiterplatte (4) ermöglicht.

In einer Ausführungsform umfasst der erste Anschluss einen ersten männlichen oder weiblichen Schraubstecker, sodass der erste männliche oder weibliche Schraubstecker eine fixe Verbindung des mindestens einen ersten Leiters mit der Leiterplatte (4) ermöglicht. In einer weiteren Ausführungsform umfasst der erste Anschluss einen ersten männlichen oder weiblichen Schraubstecker, sodass der erste männliche oder weibliche Schraubstecker eine feste Verbindung des mindestens einen ersten Leiters mit der Leiterplatte (4) ermöglicht.

In einer Ausführungsform umfasst der erste Anschluss einen ersten männlichen oder weiblichen Schraubstecker, sodass der erste männliche oder weibliche Schraubstecker zusammen mit einem ersten weiblichen oder männlichen Schraubstecker an der Leiterplatte (4) die starre Verbindung des mindestens einen ersten Leiters mit der Leiterplatte (4) ermöglicht. In einer weiteren Ausführungsform umfasst der erste Anschluss einen ersten männlichen oder weiblichen Schraubstecker, sodass der erste männliche oder weibliche Schraubstecker zusammen mit einem ersten weiblichen oder männlichen Schraubstecker an der Leiterplatte (4) eine fixe Verbindung des mindestens einen ersten Leiters mit der Leiterplatte (4) ermöglicht. In wiederum einer weiteren Ausführungsform umfasst der erste Anschluss einen ersten männlichen oder weiblichen Schraubstecker, sodass der erste männliche oder weibliche Schraubstecker zusammen mit einem ersten weiblichen oder männlichen Schraubstecker an der Leiterplatte (4) eine feste Verbindung des mindestens einen ersten Leiters mit der Leiterplatte (4) ermöglicht.

Die vorliegende Offenbarung lehrt weiterhin eine der vorgenannten Anordnungen mit einem nicht-exklusiven ersten röhrenförmigen Befestigungselement (6), die Anordnung umfassend:
ein zweites röhrenförmiges Befestigungselement (7) und mindestens einen zweiten Leiter innen im zweiten röhrenförmigen Befestigungselement (7);
wobei die Halterung (2) eine zweite Öffnung umfasst;
wobei das zweite röhrenförmige Befestigungselement (7) durch die zweite Öffnung in der Halterung (2) geführt ist;
die Anordnung zusätzlich umfassend einen zweiten Anschluss zur starren Verbindung des mindestens einen zweiten Leiters mit der Leiterplatte (4);
wobei das zweite röhrenförmige Befestigungselement (7) ein Ende umfasst, welches von der Halterung (2) weggerichtet ist; und
wobei der zweite Anschluss am Ende des zweiten röhrenförmigen Befestigungselementes (7) angeordnet ist.

Das zweite röhrenförmige Befestigungselement (7) ist verschieden vom ersten röhrenförmigen Befestigungselement (6). Der mindestens eine zweite Leiter ist verschieden vom mindestens einen ersten Leiter. Die mindestens eine zweite Öffnung in der Halterung (2) ist verschieden von der mindestens einen ersten Öffnung in der Halterung (2). Der zweite Anschluss ist verschieden vom ersten Anschluss.

Gemäss einer Ausführungsform umfasst das zweite röhrenförmige Befestigungselement (7) ein zweites und im Wesentlichen zylindrisches Befestigungselement (7). Gemäss einer speziellen Ausführungsform umfasst das zweite röhrenförmige Befestigungselement (7) ein zweites und zylindrisches Befestigungselement (7).

Der zweite Anschluss ist vorzugsweise ein zweiter Anschluss zur fixen Verbindung des mindestens einen zweiten Leiters mit der Leiterplatte (4). Der zweite Anschluss kann ferner ein zweiter Anschluss zur festen Verbindung des mindestens einen zweiten Leiters mit der Leiterplatte (4) sein.

In einer Ausführungsform umfasst der zweite Anschluss eine zweite starre Verbindung des mindestens einen zweiten Leiters mit der Leiterplatte (4). In einer verwandten Ausführungsform umfasst der zweite Anschluss eine zweite fixe Verbindung des mindestens einen zweiten Leiters mit der Leiterplatte (4). In wiederum einer verwandten Ausführungsform umfasst der zweite Anschluss eine zweite feste Verbindung des mindestens einen zweiten Leiters mit der Leiterplatte (4).

Das zweite röhrenförmige Befestigungselement (7) umfasst ein Ende, welches zur Leiterplatte (4) gerichtet ist. Vorzugsweise sind der mindestens eine Vorsprung und das zweite röhrenförmige Befestigungselement (7) jeweils von der Halterung (2) weggerichtet. Idealerweise umfasst der mindestens eine Vorsprung ein erstes Ende und ein zweites Ende, wobei das zweite Ende des mindestens einen Vorsprunges verschieden ist vom ersten Ende des mindestens einen Vorsprunges, wobei das erste Ende des mindestens einen Vorsprunges den mindestens einen Vorsprung mit der Halterung (2) verbindet, wobei das zweite Ende des mindestens einen Vorsprunges zur mechanischen Befestigung der Leiterplatte (4) an dem mindestens einen Vorsprung und an der Halterung (2) ist, wobei das zweite Ende des mindestens einen Vorsprunges eine zweite Richtung definiert, wobei das zweite Ende des mindestens einen Vorsprunges und das Ende des zweiten röhrenförmigen Befestigungselementes (7) in der zweiten Richtung von der Halterung (2) weggerichtet sind. Die erste Richtung entspricht vorzugsweise der zweiten Richtung. Die erste Richtung ist idealerweise gleich der zweiten Richtung.

Die vorliegende Offenbarung lehrt weiterhin eine der vorgenannten Anordnungen mit einem zweiten Anschluss,
die Anordnung zusätzlich umfassend die Leiterplatte (4);
wobei die Leiterplatte (4) anhand des mindestens einen Vorsprunges mechanisch an der Halterung (2) befestigt ist; und
wobei der mindestens eine zweite Leiter mit der Leiterplatte (4) anhand des zweiten Anschlusses starr verbunden ist.

Die vorliegende Offenbarung lehrt ferner eine der vorgenannten Anordnungen mit einem zweite röhrenförmigen Befestigungselement (7),
wobei das zweite röhrenförmige Befestigungselement (7) mechanisch derart fest mit der Halterung (2) verbunden ist, dass die Halterung (2) gegenüber dem zweiten röhrenförmigen Befestigungselement (7) im Wesentlichen unbeweglich ist.

Idealerweise ist das zweite röhrenförmige Befestigungselement (7) mechanisch derart fest mit der Halterung (2) verbunden, dass die Halterung (2) gegenüber dem zweiten röhrenförmigen Befestigungselement (7) unbeweglich ist.

In einer Ausführungsform ist das zweite röhrenförmige Befestigungselement (7) derart fest mit der Halterung (2) verschraubt, dass die Halterung (2) gegenüber dem zweiten röhrenförmigen Befestigungselement (7) im Wesentlichen unbeweglich ist. In einer verwandten Ausführungsform ist das zweite röhrenförmige Befestigungselement (7) derart fest mit der Halterung (2) verschraubt, dass die Halterung (2) gegenüber dem zweiten röhrenförmigen Befestigungselement (7) unbeweglich ist. In einer weiteren Ausführungsform ist das zweite röhrenförmige Befestigungselement (7) derart fest mit der Halterung (2) verklebt, dass die Halterung (2) gegenüber dem zweiten röhrenförmigen Befestigungselement (7) im Wesentlichen unbeweglich ist. In einer verwandten Ausführungsform ist das zweite röhrenförmige Befestigungselement (7) derart fest mit der Halterung (2) verklebt, dass die Halterung (2) gegenüber dem zweiten röhrenförmigen Befestigungselement (7) unbeweglich ist. In wiederum einer weiteren Ausführungsform ist das zweite röhrenförmige Befestigungselement (7) derart fest mit der Halterung (2) anhand einer Schrumpfpassung verbunden, dass die Halterung (2) gegenüber dem zweiten röhrenförmigen Befestigungselement (7) im Wesentlichen unbeweglich ist. In einer verwandten Ausführungsform ist das zweite röhrenförmige Befestigungselement (7) derart fest mit der Halterung (2) anhand einer Schrumpfpassung verbunden, dass die Halterung (2) gegenüber dem zweiten röhrenförmigen Befestigungselement (7) unbeweglich ist.

Die vorliegende Offenbarung lehrt ausserdem eine der vorstehenden Anordnungen umfassend einen zweiten Anschluss, wobei der zweite Anschluss einen zweiten elektrischen Anschluss umfasst und wobei der mindestens eine zweite Leiter mindestens einen zweiten elektrischen Leiter umfasst.

Vorzugsweise ist der zweite Anschluss ein zweiter elektrischer Anschluss. Vorzugsweise ist der mindestens eine zweite Leiter mindestens ein zweiter elektrischer Leiter.

Die vorliegende Offenbarung lehrt weiterhin eine der vorstehenden Anordnungen umfassend einen zweiten Anschluss, wobei der zweite Anschluss einen zweiten Anschluss für einen Lichtwellenleiter umfasst und wobei der mindestens eine zweite Leiter mindestens einen zweiten Lichtwellenleiter umfasst.

Vorzugsweise ist der zweite Anschluss ein zweiter Anschluss für einen Lichtwellenleiter. Vorzugsweise ist der mindestens eine zweite Leiter mindestens ein zweiter Lichtwellenleiter.

Lichtwellenleiter verschaffen Vorteile beispielsweise in Umgebungen mit Explosionsgefahr. In solchen Umgebungen sollten elektrische Verbindungen auf ein Minimum reduziert werden.

Die vorliegende Offenbarung lehrt weiterhin eine der vorstehenden Anordnungen umfassend ein zweites röhrenförmiges Befestigungselement (7), wobei das zweite röhrenförmige Befestigungselement (7) senkrecht zur Halterung (2) angeordnet ist.

Vorzugsweise hat das zweite röhrenförmige Befestigungselement (7) eine zweite Symmetrieachse;
wobei das zweite röhrenförmige Befestigungselement (7) im Wesentlichen zylindersymmetrisch zu der zweiten Symmetrieachse des zweiten röhrenförmigen Befestigungselementes (7) ist; und
wobei die zweite Symmetrieachse des zweiten röhrenförmigen Befestigungselementes (7) senkrecht zur Halterung (2) verläuft.

Idealerweise hat das zweite röhrenförmige Befestigungselement (7) eine zweite Symmetrieachse;
wobei das zweite röhrenförmige Befestigungselement (7) zylindersymmetrisch zu der zweiten Symmetrieachse des zweiten röhrenförmigen Befestigungselementes (7) ist; und
wobei die zweite Symmetrieachse des zweiten röhrenförmigen Befestigungselementes (7) senkrecht zur Halterung (2) verläuft.

Die vorliegende Offenbarung lehrt ausserdem eine der vorgenannten Anordnungen mit einem zweite röhrenförmigen Befestigungselement (7), wobei das zweite röhrenförmige Befestigungselement (7) parallel zum ersten röhrenförmigen Befestigungselement (6) angeordnet ist.

Vorzugsweise hat das erste röhrenförmige Befestigungselement (6) eine erste Symmetrieachse und das zweite röhrenförmige Befestigungselement (7) eine zweite Symmetrieachse;
wobei das erste röhrenförmige Befestigungselement (6) im Wesentlichen zylindersymmetrisch zu der ersten Symmetrieachse des ersten röhrenförmigen Befestigungselementes (6) ist;
wobei das zweite röhrenförmige Befestigungselement (7) im Wesentlichen zylindersymmetrisch zu der zweiten Symmetrieachse des zweiten röhrenförmigen Befestigungselementes (7) ist; und
wobei die erste Symmetrieachse parallel zur zweiten Symmetrieachse ist.

Idealerweise hat das erste röhrenförmige Befestigungselement (6) eine erste Symmetrieachse und das zweite röhrenförmige Befestigungselement (7) eine zweite Symmetrieachse;
wobei das erste röhrenförmige Befestigungselement (6) zylindersymmetrisch zu der ersten Symmetrieachse des ersten röhrenförmigen Befestigungselementes (6) ist;
wobei das zweite röhrenförmige Befestigungselement (7) zylindersymmetrisch zu der zweiten Symmetrieachse des zweiten röhrenförmigen Befestigungselementes (7) ist; und
wobei die erste Symmetrieachse parallel zur zweiten Symmetrieachse ist.

Die vorliegende Offenbarung lehrt zudem eine der vorgenannten Anordnungen mit einem zweite röhrenförmigen Befestigungselement (7),
wobei der zweite Anschluss einen zweiten männlichen oder weiblichen Schraubstecker umfasst, wobei der zweite männliche oder weibliche Schraubstecker ein elastisches Element umfasst, sodass das elastische Element und der zweite männliche oder weibliche Schraubstecker die starre Verbindung des mindestens einen zweiten Leiters mit der Leiterplatte (4) ermöglichen.

In einer Ausführungsform umfasst der zweite Anschluss einen zweiten männlichen oder weiblichen Schraubstecker, wobei der zweite männliche oder weibliche Schraubstecker ein elastisches Element umfasst, sodass das elastische Element und der zweite männliche oder weibliche Schraubstecker die fixe Verbindung des mindestens einen zweiten Leiters mit der Leiterplatte (4) ermöglichen. In einer weiteren Ausführungsform umfasst der zweite Anschluss einen zweiten männlichen oder weiblichen Schraubstecker, wobei der zweite männliche oder weibliche Schraubstecker ein elastisches Element umfasst, sodass das elastische Element und der zweite männliche oder weibliche Schraubstecker die feste Verbindung des mindestens einen zweiten Leiters mit der Leiterplatte (4) ermöglichen.

In einer Ausführungsform umfasst der zweite Anschluss einen zweiten männlichen oder weiblichen Schraubstecker, wobei der zweite männliche oder weibliche Schraubstecker ein elastisches Element umfasst, sodass das elastische Element und der zweite männliche oder weibliche Schraubstecker zusammen mit einem zweiten weiblichen oder männlichen Schraubstecker an der Leiterplatte (4) die starre Verbindung des mindestens einen zweiten Leiters mit der Leiterplatte (4) ermöglichen. In einer weiteren Ausführungsform umfasst der zweite Anschluss einen zweiten männlichen oder weiblichen Schraubstecker, wobei der zweite männliche oder weibliche Schraubstecker ein elastisches Element umfasst, sodass das elastische Element und der zweite männliche oder weibliche Schraubstecker zusammen mit einem zweiten weiblichen oder männlichen Schraubstecker an der Leiterplatte (4) die fixe Verbindung des mindestens einen zweiten Leiters mit der Leiterplatte (4) ermöglichen. In wiederum einer weiteren Ausführungsform umfasst der zweite Anschluss einen zweiten männlichen oder weiblichen Schraubstecker, wobei der zweite männliche oder weibliche Schraubstecker ein elastisches Element umfasst, sodass das elastische Element und der zweite männliche oder weibliche Schraubstecker zusammen mit einem zweiten weiblichen oder männlichen Schraubstecker an der Leiterplatte (4) die feste Verbindung des mindestens einen zweiten Leiters mit der Leiterplatte (4) ermöglichen.

Das elastische Element des zweiten männlichen oder weiblichen Schraubsteckers ermöglicht eine laterale Verschiebung von Kontakten. In der Folge können Toleranzen eher eingehalten werden.

Die vorliegende Offenbarung lehrt ferner ein Gerät, insbesondere ein elektrisches Gerät, umfassend eine der vorgenannten Anordnungen. Vorzugsweise umfasst das Gerät, insbesondere das elektrische Gerät, eine Gehäusewand (1), wobei die Halterung (2) einer der vorgenannten Anordnungen an der Gehäusewand (1) mechanisch befestigt ist. Idealerweise umfasst die Gehäusewand (1) eine Innenseite und die Halterung (2) ist an der Innenseite der Gehäusewand (1) befestigt. Das Gerät, insbesondere das elektrische Gerät, umfasst einen Innenraum und die Innenseite der Gehäusewand (1) begrenzt den Innenraum.

Das Genannte bezieht sich auf einzelne Ausführungsformen der vorliegenden Offenbarung. Verschiedene Änderungen an den Ausführungsformen können vorgenommen werden, ohne von der zu Grunde liegenden Idee abzuweichen und ohne den Rahmen dieser Offenbarung zu verlassen. Der Gegenstand der vorliegenden Offenbarung ist definiert über deren Ansprüche. Es können verschiedenste Änderungen vorgenommen werden, ohne den Schutzbereich der folgenden Ansprüche zu verlassen.

### Bezugszeichen

- 1:: Gehäusewand
- 2:: Halterung, insbesondere Leiterplattenhalter
- 3:: Schraubenmutter, insbesondere Haltemutter und/oder Flachmutter
- 4:: Leiterplatte
- 5:: Befestigungen, insbesondere Schrauben und/oder Nieten
- 6:: erstes Befestigungselement, insbesondere erster Gewindebolzen
- 7:: zweites Befestigungselement, insbesondere zweiter Gewindebolzen

## Patentansprüche

1. Anordnung zur Befestigung einer Leiterplatte (4), die Anordnung umfassend:
ein erstes röhrenförmiges Befestigungselement (6) und mindestens einen ersten Leiter innen im ersten röhrenförmigen Befestigungselement (6);
die Anordnung zusätzlich umfassend eine Halterung (2) für die Leiterplatte (4);
wobei die Halterung (2) mindestens einen Vorsprung zur mechanischen Befestigung der Leiterplatte (4) umfasst;
wobei die Halterung (2) eine erste Öffnung umfasst;
wobei das erste röhrenförmige Befestigungselement (6) durch die erste Öffnung in der Halterung (2) geführt ist;
wobei das erste röhrenförmige Befestigungselement (6) mechanisch derart fest mit der Halterung (2) verbunden ist, dass die Halterung (2) gegenüber dem ersten röhrenförmigen Befestigungselement (6) im Wesentlichen unbeweglich ist;
die Anordnung zusätzlich umfassend einen ersten Anschluss zur starren Verbindung des mindestens einen ersten Leiters mit der Leiterplatte (4);
wobei das erste röhrenförmige Befestigungselement (6) ein Ende umfasst, welches von der Halterung (2) weggerichtet ist; und
wobei der erste Anschluss am Ende des ersten röhrenförmigen Befestigungselementes (6) angeordnet ist.

2. Die Anordnung gemäss Anspruch 1, wobei der erste Anschluss einen ersten elektrischen Anschluss umfasst und wobei der mindestens eine erste Leiter mindestens einen ersten elektrischen Leiter umfasst.

3. Die Anordnung gemäss einem der Ansprüche 1 bis 2, wobei der erste Anschluss einen ersten Anschluss für einen Lichtwellenleiter umfasst und wobei der mindestens eine erste Leiter mindestens einen ersten Lichtwellenleiter umfasst.

4. Die Anordnung gemäss einem der Ansprüche 1 bis 3, wobei das erste röhrenförmige Befestigungselement (6) senkrecht zur Halterung (2) angeordnet ist.

5. Die Anordnung gemäss einem der Ansprüche 1 bis 4,
wobei die Halterung (2) und der mindestens eine Vorsprung zur mechanischen Befestigung der Leiterplatte (4) aus einem Stück gefertigt sind.

6. Die Anordnung gemäss einem der Ansprüche 1 bis 5,
wobei die Anordnung zusätzlich eine Gehäusewand (1) umfasst;
wobei die Gehäusewand (1) eine erste Öffnung umfasst;
wobei das erste röhrenförmige Befestigungselement (6) durch die erste Öffnung in der Gehäusewand (1) geführt ist; und
wobei das erste röhrenförmige Befestigungselement (6) mechanisch derart fest mit der Gehäusewand (1) verbunden ist, dass die Gehäusewand (1) gegenüber dem ersten röhrenförmigen Befestigungselement (6) im Wesentlichen unbeweglich ist.

7. Die Anordnung gemäss Anspruch 6,
wobei die Halterung (2) eine erste und eine zweite Seite umfasst;
wobei die zweite Seite der Halterung (2) verschieden ist von der ersten Seite der Halterung (2);
wobei die zweite Seite der Halterung (2) der ersten Seite der Halterung (2) gegenüberliegt;
wobei die erste Seite der Halterung (2) in Richtung der Gehäusewand (1) gerichtet ist; und
wobei der mindestens eine Vorsprung zur mechanischen Befestigung der Leiterplatte (4) von der zweiten Seite der Halterung (2) hervorragt.

8. Die Anordnung gemäss einem der Ansprüche 6 bis 7, wobei die Halterung (2) zwischen der Gehäusewand (1) und dem ersten Anschluss angeordnet ist.

9. Die Anordnung gemäss einem der Ansprüche 6 bis 8, wobei das erste röhrenförmige Befestigungselement (6) senkrecht zur Gehäusewand (1) angeordnet ist.

10. Die Anordnung gemäss einem der Ansprüche 6 bis 9, wobei das erste röhrenförmige Befestigungselement (6) die einzige mechanische Verbindung zwischen der Halterung (2) und der Gehäusewand (1) ist.

11. Die Anordnung gemäss einem der Ansprüche 1 bis 10,
wobei der erste Anschluss einen ersten männlichen oder weiblichen Schraubstecker umfasst, sodass der erste männliche oder weibliche Schraubstecker die starre Verbindung des mindestens einen ersten Leiters mit der Leiterplatte (4) ermöglicht.

12. Die Anordnung gemäss einem der Ansprüche 1 bis 9, die Anordnung umfassend:
ein zweites röhrenförmiges Befestigungselement (7) und mindestens einen zweiten Leiter innen im zweiten röhrenförmigen Befestigungselement (7);
wobei die Halterung (2) eine zweite Öffnung umfasst;
wobei das zweite röhrenförmige Befestigungselement (7) durch die zweite Öffnung in der Halterung (2) geführt ist;
die Anordnung zusätzlich umfassend einen zweiten Anschluss zur starren Verbindung des mindestens einen zweiten Leiters mit der Leiterplatte (4);
wobei das zweite röhrenförmige Befestigungselement (7) ein Ende umfasst, welches von der Halterung (2) weggerichtet ist; und
wobei der zweite Anschluss am Ende des zweiten röhrenförmigen Befestigungselementes (7) angeordnet ist.

13. Die Anordnung gemäss Anspruch 12,
wobei das zweite röhrenförmige Befestigungselement (7) mechanisch derart fest mit der Halterung (2) verbunden ist, dass die Halterung (2) gegenüber dem zweiten röhrenförmigen Befestigungselement (7) im Wesentlichen unbeweglich ist.

14. Die Anordnung gemäss einem der Ansprüche 12 bis 13, wobei das zweite röhrenförmige Befestigungselement (7) parallel zum ersten röhrenförmigen Befestigungselement (6) angeordnet ist.

15. Die Anordnung gemäss einem der Ansprüche 12 bis 14,
wobei der zweite Anschluss einen zweiten männlichen oder weiblichen Schraubstecker umfasst, wobei der zweite männliche oder weibliche Schraubstecker ein elastisches Element umfasst, sodass das elastische Element und der zweite männliche oder weibliche Schraubstecker die starre Verbindung des mindestens einen zweiten Leiters mit der Leiterplatte (4) ermöglichen.

## Geänderte Patentansprüche

### Geänderte Patentansprüche gemäss Regel 137(2) EPÜ.

1. Anordnung zur Befestigung einer Leiterplatte (4), die Anordnung umfassend:
ein erstes röhrenförmiges Befestigungselement (6) und mindestens einen ersten Leiter innen im ersten röhrenförmigen Befestigungselement (6);
die Anordnung zusätzlich umfassend eine Halterung (2) für die Leiterplatte (4);
wobei die Halterung (2) mindestens einen Vorsprung zur mechanischen Befestigung der Leiterplatte (4) umfasst;
wobei die Halterung (2) eine erste Öffnung umfasst;
wobei das erste röhrenförmige Befestigungselement (6) durch die erste Öffnung in der Halterung (2) geführt ist;
wobei das erste röhrenförmige Befestigungselement (6) mechanisch derart fest mit der Halterung (2) verbunden ist, dass die Halterung (2) gegenüber dem ersten röhrenförmigen Befestigungselement (6) im Wesentlichen unbeweglich ist;
die Anordnung zusätzlich umfassend einen ersten Anschluss zur starren Verbindung des mindestens einen ersten Leiters mit der Leiterplatte (4);
wobei das erste röhrenförmige Befestigungselement (6) ein Ende umfasst, welches von der Halterung (2) weggerichtet ist;
wobei der erste Anschluss am Ende des ersten röhrenförmigen Befestigungselementes (6) angeordnet ist;
**dadurch gekennzeichnet, dass**
die Anordnung zusätzlich eine Gehäusewand (1) umfasst;
wobei die Gehäusewand (1) eine erste Öffnung umfasst;
wobei das erste röhrenförmige Befestigungselement (6) durch die erste Öffnung in der Gehäusewand (1) geführt ist;
wobei das erste röhrenförmige Befestigungselement (6) mechanisch derart fest mit der Gehäusewand (1) verbunden ist, dass die Gehäusewand (1) gegenüber dem ersten röhrenförmigen Befestigungselement (6) im Wesentlichen unbeweglich ist;
wobei die Halterung (2) eine erste und eine zweite Seite umfasst;
wobei die zweite Seite der Halterung (2) verschieden ist von der ersten Seite der Halterung (2) und die zweite Seite der Halterung (2) der ersten Seite der Halterung (2) gegenüberliegt und die erste Seite der Halterung (2) in Richtung der Gehäusewand (1) gerichtet ist;
wobei der mindestens eine Vorsprung zur mechanischen Befestigung der Leiterplatte (4) von der zweiten Seite der Halterung (2) hervorragt; und
wobei die Halterung (2) zwischen der Gehäusewand (1) und dem ersten Anschluss angeordnet ist.

2. Die Anordnung gemäss Anspruch 1, wobei der erste Anschluss einen ersten elektrischen Anschluss umfasst und wobei der mindestens eine erste Leiter mindestens einen ersten elektrischen Leiter umfasst.

3. Die Anordnung gemäss einem der Ansprüche 1 bis 2, wobei der erste Anschluss einen ersten Anschluss für einen Lichtwellenleiter umfasst und wobei der mindestens eine erste Leiter mindestens einen ersten Lichtwellenleiter umfasst.

4. Die Anordnung gemäss einem der Ansprüche 1 bis 3, wobei das erste röhrenförmige Befestigungselement (6) senkrecht zur Halterung (2) angeordnet ist.

5. Die Anordnung gemäss einem der Ansprüche 1 bis 4,
wobei die Halterung (2) und der mindestens eine Vorsprung zur mechanischen Befestigung der Leiterplatte (4) aus einem Stück gefertigt sind.

6. Die Anordnung gemäss einem der Ansprüche 1 bis 5, wobei das erste röhrenförmige Befestigungselement (6) senkrecht zur Gehäusewand (1) angeordnet ist.

7. Die Anordnung gemäss einem der Ansprüche 1 bis 6, wobei das erste röhrenförmige Befestigungselement (6) die einzige mechanische Verbindung zwischen der Halterung (2) und der Gehäusewand (1) ist.

8. Die Anordnung gemäss einem der Ansprüche 1 bis 7,
wobei der erste Anschluss einen ersten männlichen oder weiblichen Schraubstecker umfasst, sodass der erste männliche oder weibliche Schraubstecker die starre Verbindung des mindestens einen ersten Leiters mit der Leiterplatte (4) ermöglicht.

9. Die Anordnung gemäss einem der Ansprüche 1 bis 6, die Anordnung umfassend:
ein zweites röhrenförmiges Befestigungselement (7) und mindestens einen zweiten Leiter innen im zweiten röhrenförmigen Befestigungselement (7);
wobei die Halterung (2) eine zweite Öffnung umfasst;
wobei das zweite röhrenförmige Befestigungselement (7) durch die zweite Öffnung in der Halterung (2) geführt ist;
die Anordnung zusätzlich umfassend einen zweiten Anschluss zur starren Verbindung des mindestens einen zweiten Leiters mit der Leiterplatte (4);
wobei das zweite röhrenförmige Befestigungselement (7) ein Ende umfasst, welches von der Halterung (2) weggerichtet ist; und
wobei der zweite Anschluss am Ende des zweiten röhrenförmigen Befestigungselementes (7) angeordnet ist.

10. Die Anordnung gemäss Anspruch 9,
wobei das zweite röhrenförmige Befestigungselement (7) mechanisch derart fest mit der Halterung (2) verbunden ist, dass die Halterung (2) gegenüber dem zweiten röhrenförmigen Befestigungselement (7) im Wesentlichen unbeweglich ist.

11. Die Anordnung gemäss einem der Ansprüche 9 bis 10, wobei das zweite röhrenförmige Befestigungselement (7) parallel zum ersten röhrenförmigen Befestigungselement (6) angeordnet ist.

12. Die Anordnung gemäss einem der Ansprüche 9 bis 11,
wobei der zweite Anschluss einen zweiten männlichen oder weiblichen Schraubstecker umfasst, wobei der zweite männliche oder weibliche Schraubstecker ein elastisches Element umfasst, sodass das elastische Element und der zweite männliche oder weibliche Schraubstecker die starre Verbindung des mindestens einen zweiten Leiters mit der Leiterplatte (4) ermöglichen.
